# EUROPEAN PATENT APPLICATION

(11) **EP 2 110 398 A1**
(43) Date of publication of application: **21.10.2009**
(21) Application number: 08704330.3
(22) Date of filing: 01.02.2008
(51) Int. Cl.: C08G 61/02, C08G 61/12

(54) **METHOD FOR PRODUCING STRUCTURE WHEREIN AROMATIC POLYMER IS BONDED TO BASE, STRUCTURE HAVING AROMATIC POLYMER CHAIN BONDED TO CONDUCTIVE BASE, AND ELECTRONIC DEVICE COMPRISING THE STRUCTURE**

(30) Priority: 01.02.2007 JP 2007023449; 15.06.2007 JP 2007159439
(71) Applicant: Sumitomo Chemical Company, Limited, Tokyo 104-8260 (JP)
(72) Inventor: TANAKA, Kenta, Tsukuba-shi Ibaraki 305-0045 (JP); HIGASHIMURA, Hideyuki, Tsukuba-shi Ibaraki 305-0045 (JP); YOKOZAWA, Tsutomu, Yokohama-shi Kanagawa 241-0826 (JP); ISHIKAWA, Rui, Tsukuba-shi Ibaraki 300-3261 (JP)
(74) Representative: Duckworth, Timothy John
(86) International application number: PCT/JP2008/051621
(87) International publication number: WO 2008/093820

(57) **Abstract**

Disclosed is a method for efficiently producing a structure wherein an aromatic polymer is bonded to a base. Also disclosed is such a structure wherein the base is electrically conductive. Specifically disclosed is a method for producing a structure, which comprises a step for polycondensing an aromatic compound represented by the formula (I) below in the presence of a polymerization catalyst and a base having a group represented by the formula (II) below. 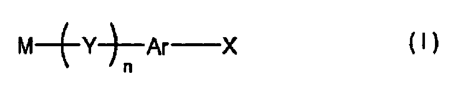 (In the formula (I), Ar represents a divalent group composed of an aromatic ring; X represents a halogen atom or the like; Y represents an oxygen atom, a sulfur atom, an imino group or the like; n represents 0 or 1; and M represents a hydrogen atom, -B(OQ¹)₂ (wherein Q¹ represents a hydrogen atom, a hydrocarbon group or the like) or the like.)

—Ar^{a}—(X^{a})ₚ (II)

(In the formula (II), Ar^{a} represents a group having a valence of (p + 1) and composed of an aromatic ring; X^{a} represents a halogen atom or a monovalent group expressed as -SO₃Q^{a} (wherein Q^{a} represents a substituted or unsubstituted hydrocarbon group); p represents an integer not less than 1, and when p is an integer not less than 2, the plurality of X^{a'}s may be the same as or different from each other.)

## Description

### Technical Field

The present invention relates to a method for producing a structure having a substrate and an aromatic polymer bonded to it.

### Background Art

It has been known that an aromatic polymer wherein main chain bonds are connected through conjugated ones, has excellent characteristics in the points of electric characteristics, optical characteristics, heat resistance, dynamic characteristics, and the like, and is useful for advanced functional materials such as conductive materials, photoelectric conversion materials, luminescent materials, nonlinear optical materials, materials for a battery, electronic part materials, materials for an automobile, and the like (Non-Patent Document 1). Particularly in applications such as conductive materials, photoelectric conversion materials, luminescent materials, and the like, there are required things wherein an aromatic polymer is bonded to a substrate.

There is known a method for polymerizing a monomer with an initiating group bonded to the surface of a substrate such as a metal insoluble in a solvent for the purpose of modifying the surface of the substrate. For example, Fukuda et al. has realized living radical polymerization from the surface of a substrate, and thereby there has been obtained a structure wherein the terminals of polymer chains are bonded to the surface of a substrate. However, this method cannot be applied to an aromatic polymer.

As a method for obtaining a structure wherein the terminals of aromatic polymers are bonded to the surface of a substrate, there are known many methods using a polymer having a terminal group which can be bonded to the surface of a substrate, but they are bad in reaction efficiency and working efficiency because of presence of polymerization step and bonding step to the surface of a substrate. Therefore, they have limitations for industrial practical use. As a method of conducting reaction for bonding to the surface of a substrate simultaneously with polymerization step, as shown by, for example, Beinhoff et al., there is known a method of conducting polymerization of a monomer having two brominated aromatic rings in the presence of a Ni(O) catalyst on the surface of a substrate which has also brominated aromatic rings by use of Yamamoto coupling (Non-Patent Document 2).

However, the above method using Yamamoto coupling has a problem that among the resultant aromatic polymers the proportion of the resultant polymers bonded to the substrate is small and that of the resultant polymers not bonded thereto is large.

Non-Patent Document 1: Chem. Rev. 102, 1359(2002)
Non-Patent Document 2: Langmuir 22, 2411(2006)

### Disclosure of the Invention

### Problem to be Solved by the Invention

Thus, the problem of the present invention resides in providing a method for producing a structure, which comprises efficiently obtaining a structure of the configuration wherein an aromatic polymer is bonded to a base polymer.

### Means for Solving the Problem

The present inventors have devoted themselves to research, and consequently have found that the above problem can be solved by placing an initiating group for chain polymerization wherein monomers are bonded in a chain reaction, on the surface or the like of a substrate.

That is, the present invention provides, as a means for solving the problem, a method for producing a structure having a substrate and an aromatic polymer bonded to the substrate, which comprises the step of polycondensing an aromatic compound represented by the undermentioned general formula (I) in a solvent in the presence of a polymerization catalyst and a substrate having a group represented by the undermentioned general formula (II).

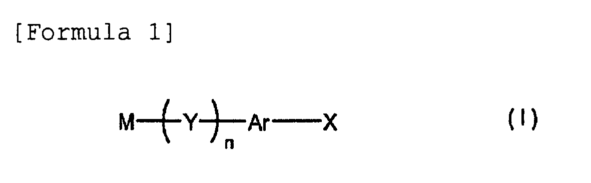

In the formula, Ar is a divalent group comprising an aromatic ring,
X is a halogen atom, nitro group, or a monovalent group represented by -SO₃Q wherein Q stands for a substituted or unsubstituted hydrocarbon group,
Y is an oxygen atom, sulfur atom, imino group, a substituted imino group, ethenylene group, a substituted ethenylene group or ethynylene group,
n is 0 or 1,
M is a hydrogen atom, -B(OQ¹)₂ wherein two Q¹ stand for independently hydrogen atom or a hydrocarbon group or are bonded together to form a ring, -Si(Q²)₃ wherein Q² is a hydrocarbon group, -Sn(Q³)₃ wherein Q³ is a hydrocarbon group, or -Z¹(Z²)ₘ wherein Z¹ is a metal atom or a metal ion, Z² is a counter anion, and m is an integer of 0 or more.

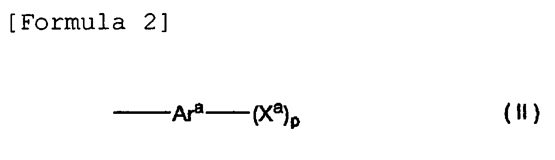

In the formula, Ar^{a} is a group having a valence of p+1 and comprising an aromatic ring, X^{a} is a halogen atom or a monovalent group represented by -SO₃Q^{a} wherein Q^{a} stands for a substituted or unsubstituted hydrocarbon group, p is an integer of 1 or more, and when p is an integer of 2 or more, the existing plural X^{a} are same as or different from each other.

The present invention also provides a structure having a substrate and an aromatic polymer bonded to the substrate, which can be obtained by the above production method.

Furthermore, the present invention provides a structure having a conductive substrate and an aromatic polymer chain having a configuration represented by the undermentioned general formula (VI), which is bonded to the conductive substrate. 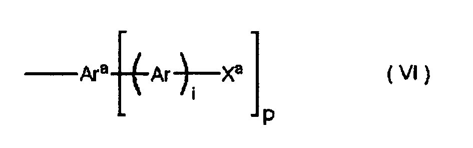 In the formula, Ar, Ar^{a}, X^{a} and p are as mentioned above, and i is a number average polymerization degree of the repeating configuration Ar.

Moreover, the present invention provides an electronic device comprising the above structure having a conductive substrate and the above aromatic polymer chain bonded to the conductive substrate.

### Advantages of the Invention

By the present invention, there can be efficiently obtained a structure wherein an aromatic polymer is bonded to a substrate.

When a substrate is, for example, an electrode, electricity can be efficiently flowed from the bonded portion of an aromatic polymer bonded to the electrode through the polymer main chain, and hence electrically excellent characteristics are shown. Thus, the present invention is useful for advanced functional materials such as conductive materials, photoelectric conversion materials, luminescent materials, materials for a battery, electronic part materials, and the like.

### Best Mode for Carrying Out the Invention

Hereinafter, the present invention is minutely explained with regard to working embodiments. In the statement of the present description and claims, the following terms are used in the meanings defined below.

The term "hydrocarbon oxy group" stands for a monovalent group represented by RO-, "hydrocarbon mercapto group" stands for a monovalent group represented by RS-, "hydrocarbon carbonyl group" stands for a monovalent group represented by R-C(=O)-, "hydrocarbon oxycarbonyl group" stands for a monovalent group represented by R-O-C(=O)-, and "hydrocarbon sulfonyl group" stands for a monovalent group represented by R-S(=O)₂-. The term "hydrocarbon-disubstituted amino group" means a monovalent group represented by (R)₂N- wherein two Rs may be same or different, and "hydrocarbon-disubstituted aminocarbonyl group" means a monovalent group represented by (R)₂N-C(=O)- wherein two Rs may be same or different. Herein, R stands for a hydrocarbon group.

### <Method for Producing Structure>

### -Monomer-

In the production method of the present invention, as a monomer there is used an aromatic compound represented by the above-mentioned general formula (I).

Ar in the above-mentioned general formula (I) is a divalent group comprising an aromatic ring. Herein, "divalent group comprising an aromatic ring" means a divalent residual group, which is formed by removing total two hydrogen atoms bonded to each of different two atoms, which are carbon atom(s) and/or hetero atom(s), preferably carbon atoms, and which are ring-constituting members of one or two or more aromatic rings present in an aromatic cyclic compound. Herein, an aromatic cyclic compound includes a carbocyclic aromatic compound and a heterocyclic aromatic compound.

As the above aromatic ring, there can be cited a monocyclic aromatic ring such as benzene ring, pyridine ring, 1,2-diazine ring, 1,3-diazine ring, 1,4-diazine ring, 1,3,5-triazine ring, furan ring, pyrrole ring, thiophene ring, pyrazole ring, imidazole ring, oxazole ring, thiazole ring, oxadiazole ring, thiadiazole ring, or azadiazole ring; a condensed polycyclic aromatic ring wherein two or more rings selected independently each other (one another) from the monocyclic aromatic rings are condensed; an aromatic ring assembly wherein two or more rings selected independently each other (one another) from the monocyclic aromatic rings and/or the condensed polycyclic aromatic rings are linked through a divalent atom or group such as single bond, methylene group, ethylene group, ethenylene group, ethynylene group, oxygen atom, sulfur atom, imino group, carbonyl group, sulfonyl group, or the like; and a bridged polycyclic aromatic ring having one or more bridges wherein two adjacent aromatic rings of the condensed polycyclic aromatic ring or the aromatic ring assembly are bridged through a divalent group such as methylene group, ethylene group, carbonyl group, sulfonyl group, or the like. Among these aromatic rings, a monocyclic aromatic ring and a bridged polycyclic aromatic ring are preferable.

In the condensed polycyclic aromatic ring, the number of condensed monocyclic aromatic rings is preferably 2 to 4, more preferably 2 to 3, and further more preferably 2. In the aromatic ring assembly, the number of linked monocyclic aromatic ring(s) and/or condensed polycyclic aromatic ring(s) is preferably 2 to 4, more preferably 2 to 3, and further more preferably 2. In the bridged polycyclic aromatic ring, the number of bridged monocyclic aromatic ring(s) and/or condensed polycyclic aromatic ring(s) is preferably 2 to 4, more preferably 2 to 3, and further more preferably 2.

The above-mentioned aromatic rings are exemplified in their basic structures, that is, in their unsubstituted states. The above-mentioned monocyclic aromatic ring includes, for example, the following structures.

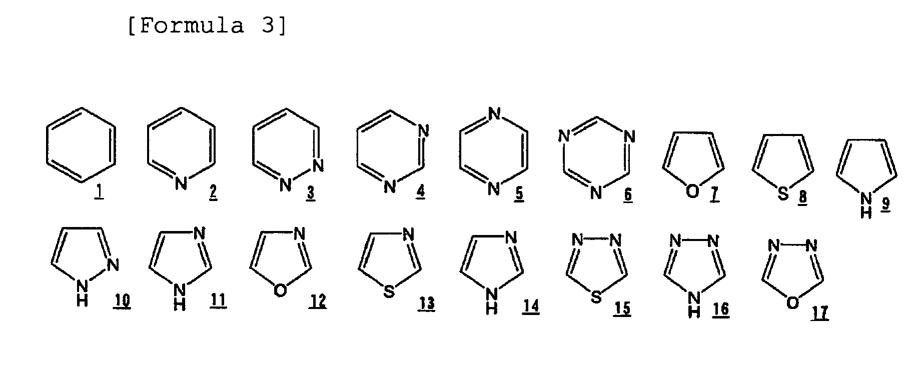

The condensed polycyclic aromatic ring includes, for example, the following structures.

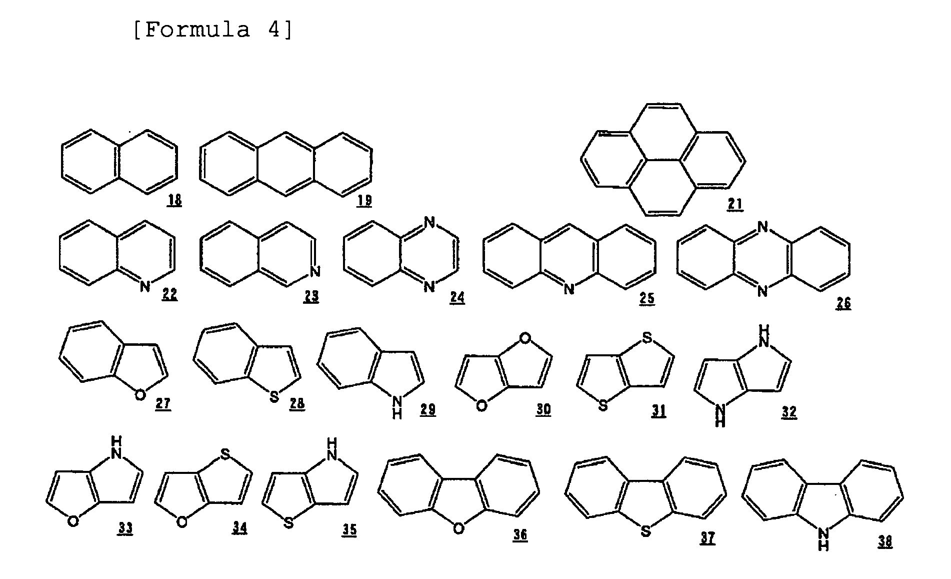

The aromatic ring assembly includes, for example, the following structures.

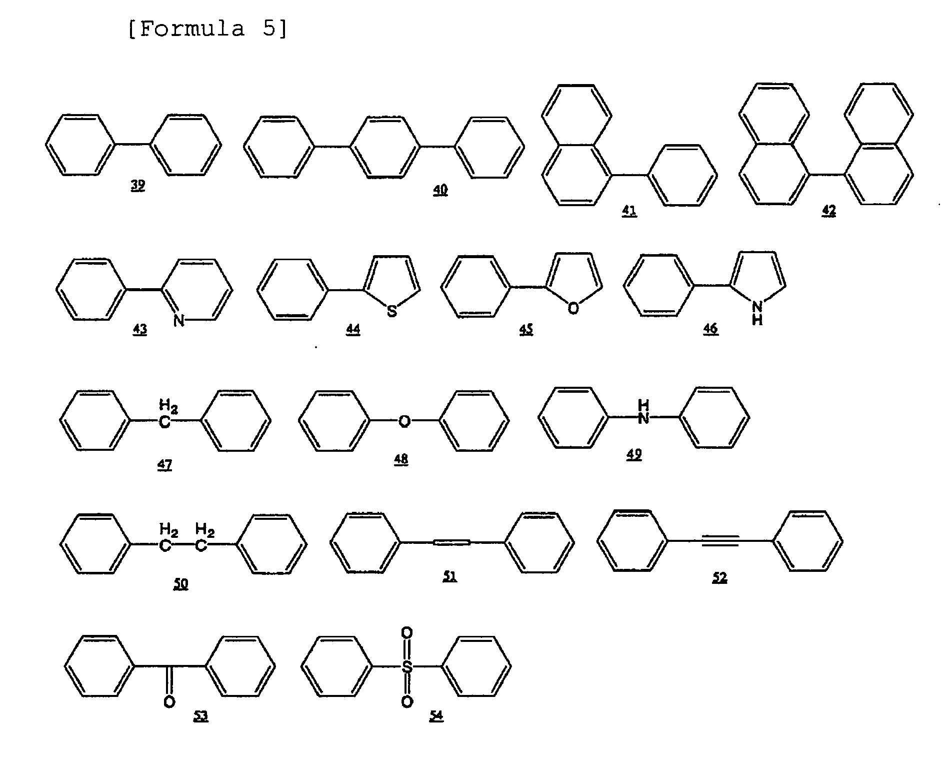

The bridged polycyclic aromatic ring includes, for example, the following structures.

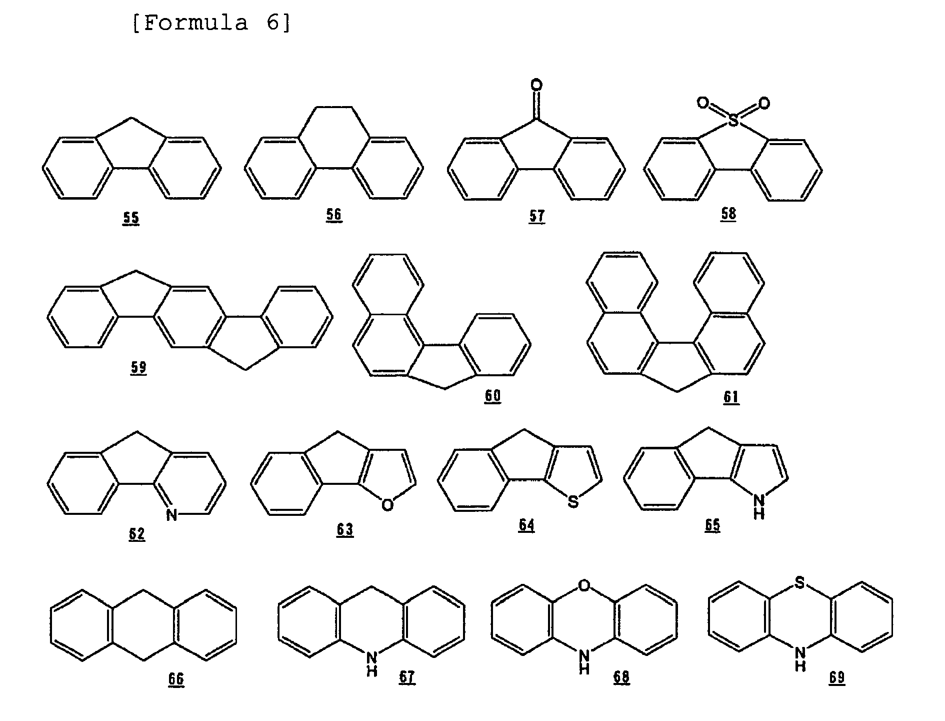

Among these aromatic rings, 1, 2, 7, 8, 9, 11, 12, 13, 14, 18, 19, 22, 23, 26, 27, 28, 29, 36, 37, 38, 39, 40, 41, 42, 43, 47, 48, 49, 50, 51, 52, 53, 54, 55, 56, 57, 59, 60, 68, and 69 are preferable; 1, 2, 7, 9, 18, 22, 36, 38, 39, 43, 48, 49, 51, 52, 53, 55, 57, and 60 are more preferable, 1, 2, 7, 18, 36, 39, 48, 53, 55, 57, and 60 are further more preferable; and 1, 2, 18, 39, 55, and 60 are especially preferable.

The above-mentioned aromatic rings preferably consist of only hydrogen atom, carbon atom, oxygen atom, and nitrogen atom, more preferably consist of only hydrogen atom, carbon atom, and oxygen atom, and further more preferably consist of only hydrogen atom, and carbon atom.

In the above-mentioned aromatic rings, hydrogen atom bonded to carbon atom constituting them may be replaced by hydroxyl group, fluorine atom, nitro group, or cyano group. In this connection, as a substituent, fluorine atom, nitro group, cyano group, a hydrocarbon group, a hydrocarbon oxy group, a hydrocarbon-disubstituted amino group, a hydrocarbon mercapto group, a hydrocarbon carbonyl group, and a hydrocarbon oxycarbonyl group are more preferable, and fluorine atom, nitro group, cyano group, a hydrocarbon group, a hydrocarbon oxy group, and a hydrocarbon-disubstituted amino group are further more preferable. Also, hydrogen atom bonded to nitrogen atom constituting an aromatic ring may be replaced by a hydrocarbon group. Furthermore, when two or more substituents are present on such carbon atom and/or nitrogen atom, two substituents selected from them may be bonded together to form a ring.

As a hydrocarbon group contained in the above-mentioned hydrocarbon group and the above-mentioned hydrocarbon oxy group, hydrocarbon-disubstituted amino group, hydrocarbon mercapto group, hydrocarbon carbonyl group, hydrocarbon oxycarbonyl group, hydrocarbon-disubstituted aminocarbonyl group, and hydrocarbon sulfonyl group, there are cited, for example, an alkyl group having about 1 to 50 carbon atoms such as methyl group, ethyl group, propyl group, isopropyl group, butyl group, isobutyl group, t-butyl group, pentyl group, hexyl group, nonyl group, dodecyl group, pentadecyl group, octadecyl group, docosyl group, or the like; a cyclic saturated hydrocarbon group having about 3 to 50 carbon atoms such as cyclopropyl group, cyclobutyl group, cyclopentyl group, cyclohexyl group, cyclononyl group, cyclododecyl group, norbornyl group, adamantyl group, or the like; an alkenyl group having about 2 to 50 carbon atoms such as ethenyl group, propenyl group, 3-butenyl group, 2-butenyl group, 2-pentenyl group, 2-hexenyl group, 2-nonenyl group, 2-dodecenyl group, or the like; an aryl group having about 6 to 50 carbon atoms such as phenyl group, 1-naphthyl group, 2-naphthyl group, 2-methylphenyl group, 3-methylphenyl group, 4-methylphenyl group, 4-ethylphenyl group, 4-propylphenyl group, 4-isopropylphenyl group, 4-butylphenyl group, 4-t-butylphenyl group, 4-hexylphenyl group, 4-cyclohexylphenyl group, 4-adamantylphenyl group, 4-phenylphenyl group, or the like; an aralkyl group having about 7 to 50 carbon atoms such as phenylmethyl group, 1-phenyleneethyl group, 2-phenylethyl group, 1-phenyl-1-propyl group, 1-phenyl-2-propyl group,2-phenyl-2-propyl group, 3-phenyl-1-propyl group, 4-phenyl-1-butyl group, 5-phenyl-1-pentyl group, 6-phenyl-1-hexyl group, or the like; and the like. A hydrocarbon group having 1 to 20 carbon atoms is preferable, a hydrocarbon group having 1 to 12 carbon atoms is more preferable, and a hydrocarbon group having 1 to 8 carbon atoms is further more preferable.

The hydrocarbon group contained in the above-mentioned hydrocarbon group and the above-mentioned hydrocarbon oxy group and the like may be substituted by, for example, hydroxyl group, fluorine atom, nitro group, cyano group, a hydrocarbon group, a hydrocarbon oxy group, a hydrocarbon-disubstituted amino group, a hydrocarbon mercapto group, a hydrocarbon carbonyl group, a hydrocarbon oxycarbonyl group, a hydrocarbon-disubstituted aminocarbonyl group, a hydrocarbon sulfonyl group, or the like.

X in the above-mentioned general formula (I) is a halogen atom, nitro group, or a group represented by -SO₃Q wherein Q stands for a substituted or unsubstituted hydrocarbon group, and preferable are a halogen atom and a group represented by -SO₃Q wherein Q stands for a substituted or unsubstituted hydrocarbon group.

The halogen atom referred to herein is fluorine atom, chlorine atom, bromine atom, or iodine atom, and preferable are chlorine atom, bromine atom, and iodine atom.

As an unsubstituted hydrocarbon group represented by Q in a group represented by -SO₃Q, there can be enumerated those mentioned above, and as a substituted hydrocarbon group there can be cited those substituted by, for example, fluorine atom. As concrete examples of a group represented by -SO₃Q, there can be cited methylsulfo group, phenylfulfo group, p-tolylsulfo group, and trifluoromethylsulfo group.

X is preferably a halogen atom or a group represented by -SO₃Q, more preferably chlorine atom, bromine atom, iodine atom, or a group represented by - SO₃Q, and further more preferably chlorine atom, bromine atom, iodine atom, or trifluoromethylsulfo group.

Y in the above-mentioned general formula (I) is oxygen atom, sulfur atom, imino group, a substituted imino group, ethenylne group, a substituted ethenylene group or ethynylene group, and n is 0 or 1.

Herein, a substituted imino group is a group represented by -N(Q')- wherein Q' stands for a substituent, and as Q' there is cited a hydrocarbon group. As concrete examples of a hydrocarbon group, there can be cited those mentioned above.

In addition, a substituted ethenylene group is a group represented by -C(Q")=C(Q"')- wherein Q" and Q"' independently stand for hydrogen atom or a substituent, but at least one of Q" and Q''' is a substituent. Herein as a substituent in Q" and Q''', there is cited a hydrocarbon group. As concrete examples of a hydrocarbon group, there can be cited those mentioned above.

Y is preferably oxygen atom, imino group, a substituted imino group, or ethynylene group, more preferably oxygen atom, imino group, or a substituted imino group, and further more preferably oxygen atom, or imino group. As n, 0 is preferable.

M in the above-mentioned general formula (I) stands for hydrogen atom, -B(OQ¹)₂, -Si(Q²)₃, -Sn(Q³)₃, or -Z¹(Z²)_{m.}

Q¹ in -B(OQ¹)₂ is hydrogen atom or a hydrocarbon group, and two Q¹ may be same as or different from each other or may be bonded together to form a ring. As a hydrocarbon group in Q¹, there are cited the above-mentioned hydrocarbon groups, and an alkyl group is preferable, methyl group, ethyl group, propyl group, isopropyl group, butyl group, isobutyl group, pentyl group, hexyl group, and nonyl group are more preferable, and methyl group, ethyl group, propyl group, butyl group, pentyl group, and hexyl group are further more preferable. When a ring is formed, a divalent hydrocarbon group formed by two Q¹ is preferably 1,2-ethylene group, 1,1,2,2-tetramethyl-1,2-ethylene group, 1,3-propylene group, 2,2-dimethyl-1,3-propylene group, or 1,2-phenylene group.

Q² in -Si(Q²)₃ is a hydrocarbon group, and three Q² may be same as or different from each other. As a hydrocarbon group in Q², there are cited the above-mentioned hydrocarbon groups, and an alkyl group is preferable, methyl group, ethyl group, propyl group, isopropyl group, butyl group, isobutyl group, pentyl group, hexyl group, and nonyl group are more preferable, and methyl group, ethyl group, propyl group, butyl group, pentyl group, and hexyl group are further more preferable.

Q³ in -Sn(Q³)₃ is a hydrocarbon group, and three Q³ may be same as or different from each other. As a hydrocarbon group in Q³, there are cited the above-mentioned hydrocarbon groups, and an alkyl group is preferable, methyl group, ethyl group, propyl group, isopropyl group, butyl group, isobutyl group, pentyl group, hexyl group, and nonyl group are more preferable, and methyl group, ethyl group, propyl group, butyl group, pentyl group, and hexyl group are further more preferable.

Z¹ in -Z¹(Z²)ₘ is a metal atom or a metal ion, Z² is a counter anion, and m is an integer of 0 or more. As concrete examples of Z¹, there can be cited atoms or ions of Li, Na, K, Rb, Cs, Be, Mg, Ca, Sr, Ba, Al, Ga, In, Tl, Pb, Sc, Ti, V, Cr, Mn, Fe, Co, Ni, Cu, Zn, Y, Zr, Nb, Mo, Tc, Ru, Rh, Ag, Cd, La, Ce, Sm, Eu, Hf, Ta, W, Re, Os, Ir, Pt, Au, Hg, and the like. Li, Na, K, Rb, Cs, Be, Mg, Ca, Sr, Ba, Al, Ga, In, Tl, Pb, Sc, Ti, Cu, Zn, Y, Zr, Ag, and Hg are preferable, Li, Na, K, Rb, Cs, Be, Mg, Ca, In, Tl, Pb, Cu, Zn, Zr, Ag, and Hg are more preferable, and Li, Na, K, Mg, Ca, Cu, and Zn are further more preferable.

As Z² there is used usually a conjugate base of Broensted acid, and as the concrete examples thereof there are cited fluoride ion, chloride ion, bromide ion, iodide ion, sulfate ion, nitrate ion, carbonate ion, perchlorate ion, tetrafluoroborate ion, hexafluorophosphate ion, methanesulfonate ion, trifluoromethanesulfonate ion, toluenesulfonate ion, acetate ion, trifluoroacetate ion, propionate ion, benzoate ion, hydroxide ion, oxide ion, methoxide ion, ethoxide ion, and the like. Chloride ion, bromide ion, iodide ion, sulfate ion, nitrate ion, carbonate ion, methanesulfonate ion, trifluoromethanesulfonate ion, toluenesulfonate ion, acetate ion, trifluoroacetate ion, propionate ion, and benzoate ion are preferable, chloride ion, bromide ion, methanesulfonate ion, trifluoromethanesulfonate ion, toluenesulfonate ion, acetate ion, trifluoroacetate ion, propionate ion, and benzoate ion are more preferable, and chloride ion, bromide ion, methanesulfonate ion, trifluoromethanesulfonate ion, acetate ion, and trifluoroacetate ion are further more preferable.

The lower-case letter, m is decided so that an aromatic compound represented by the above-mentioned general formula (I) becomes electrically neutral as a whole. In this connection, when M is Z¹(Z²)ₘ, that is, when an aromatic compound represented by the above-mentioned general formula (I) is represented by Z¹(Z²)ₘ-(Y)ₙ-Ar-X, preferably the portion Z¹(Z²)ₘ and the portion (Y)ₙ-Ar-X become electrically neutral by ionic bond, when the portion Z¹(Z²)ₘ is assumed to have the valence of +1, and when the portion (Y)ₙ-Ar-X is assumed to have the valence of -1.

M in the above-mentioned general formula (I) is preferably an atomic group containing boron atom, silicon atom, tin atom, or a metal atom, more preferably an atomic group containing boron atom, tin atom, magnesium atom, or zinc atom, and conspicuously preferably an atomic group containing boron atom.

As concrete examples of an aromatic compound represented by the above-mentioned general formula (I), there are cited the following compounds.

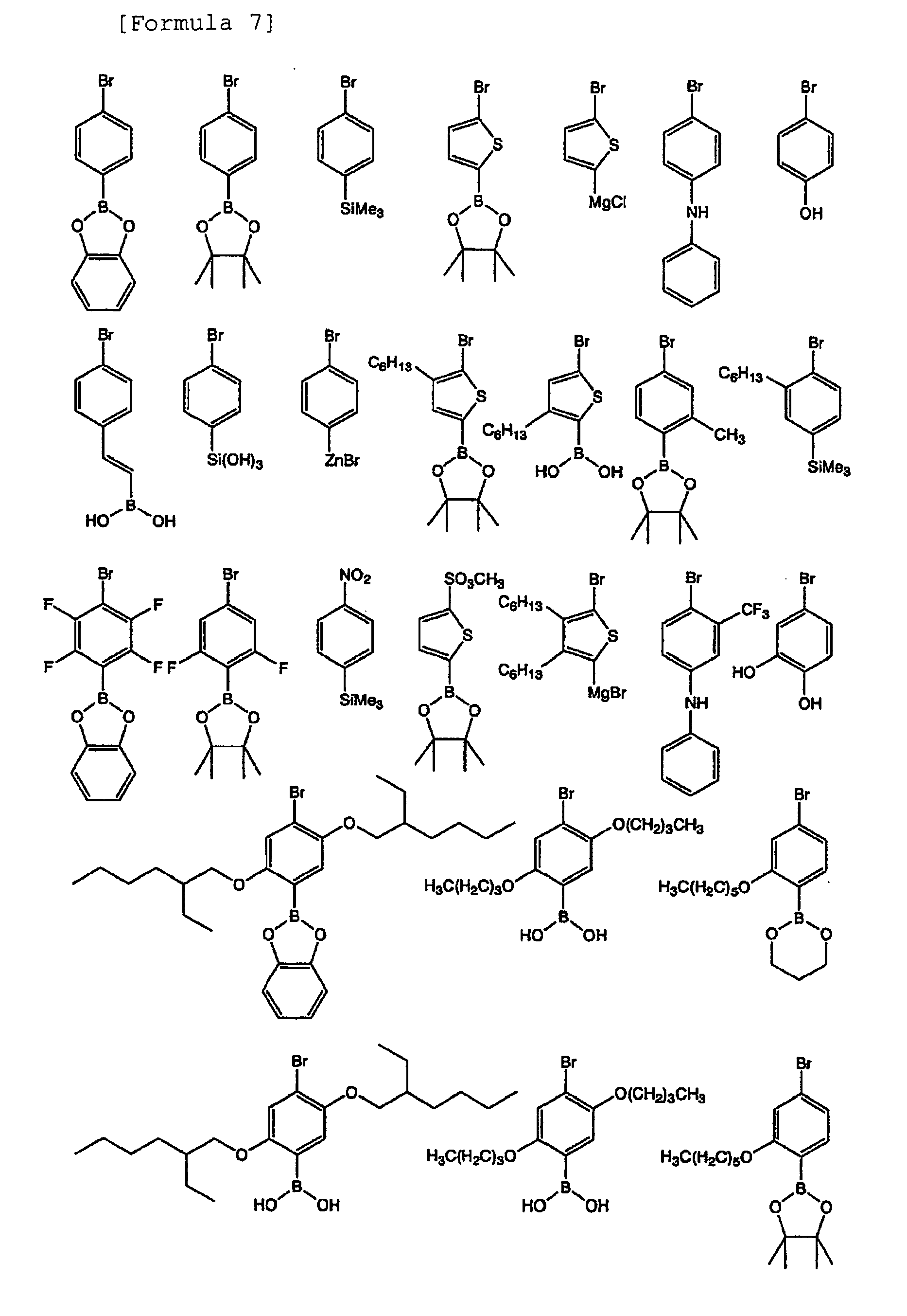

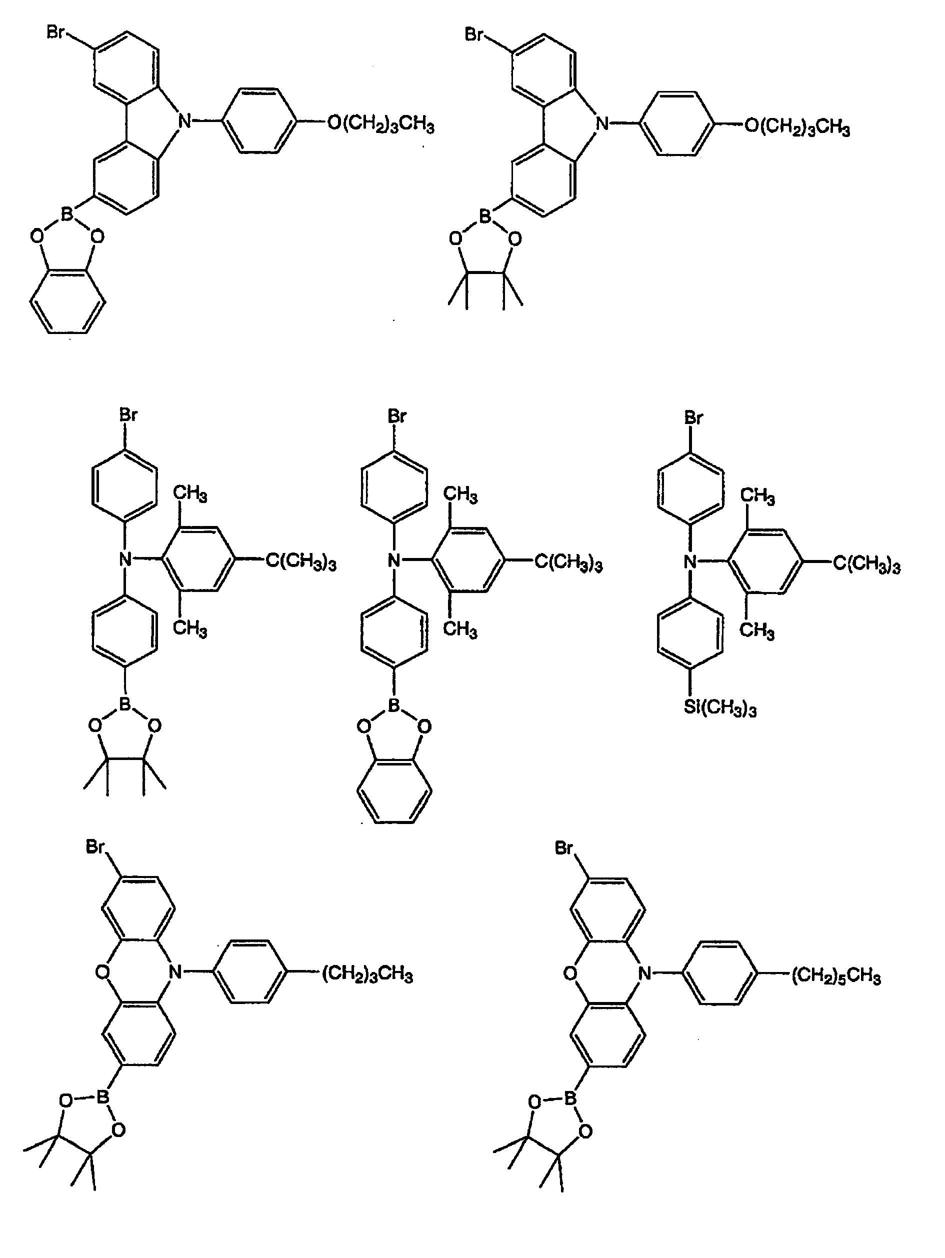

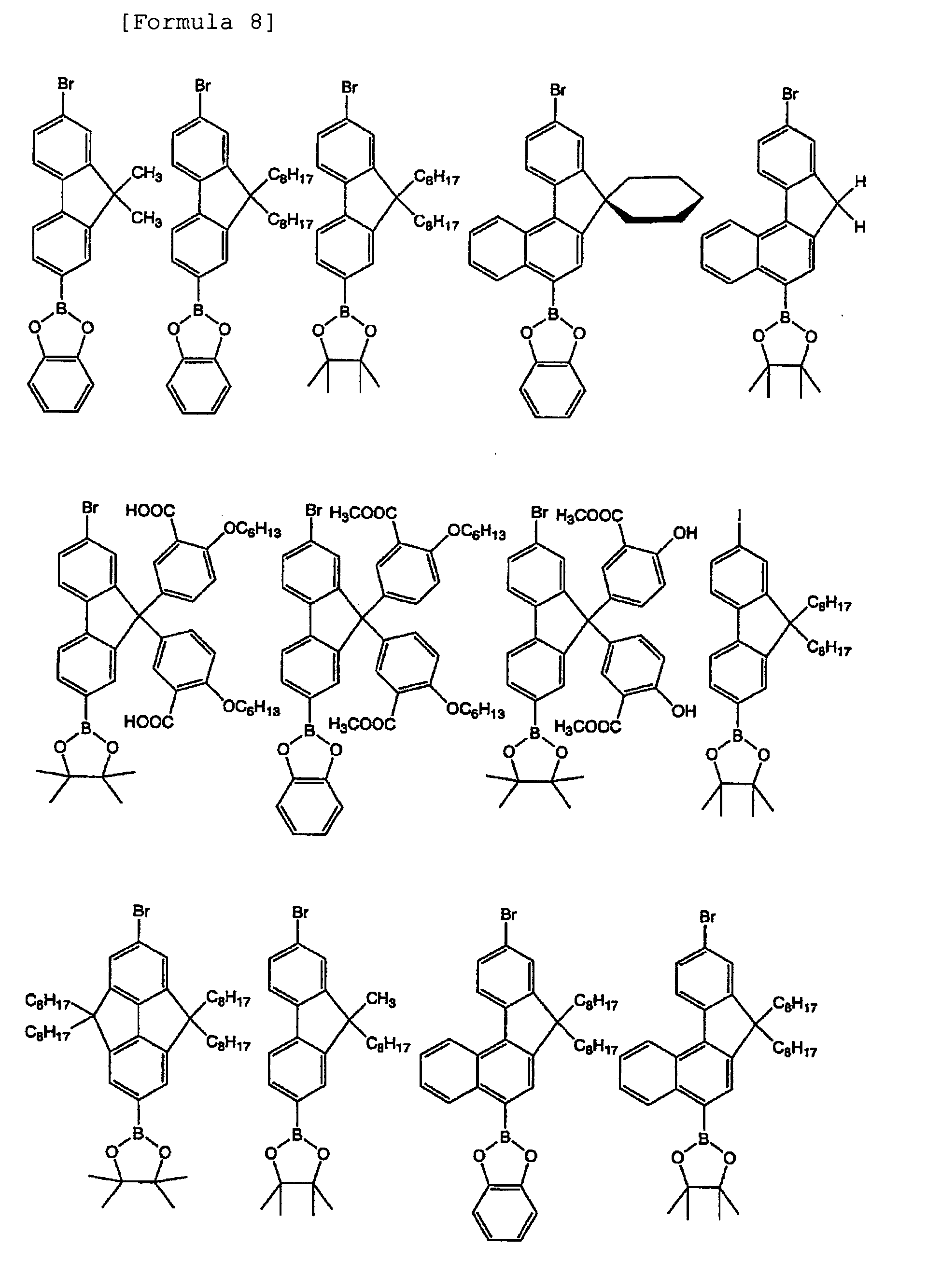

### -Polymerization Catalyst-

As a polymerization catalyst used in the method of the present invention, there are cited, for example, copper complexes, palladium complexes, nickel complexes, and the like, which contain ligands represented by the following formulas, among complexes disclosed in Chem. Rev. 102, 1359 (2002).

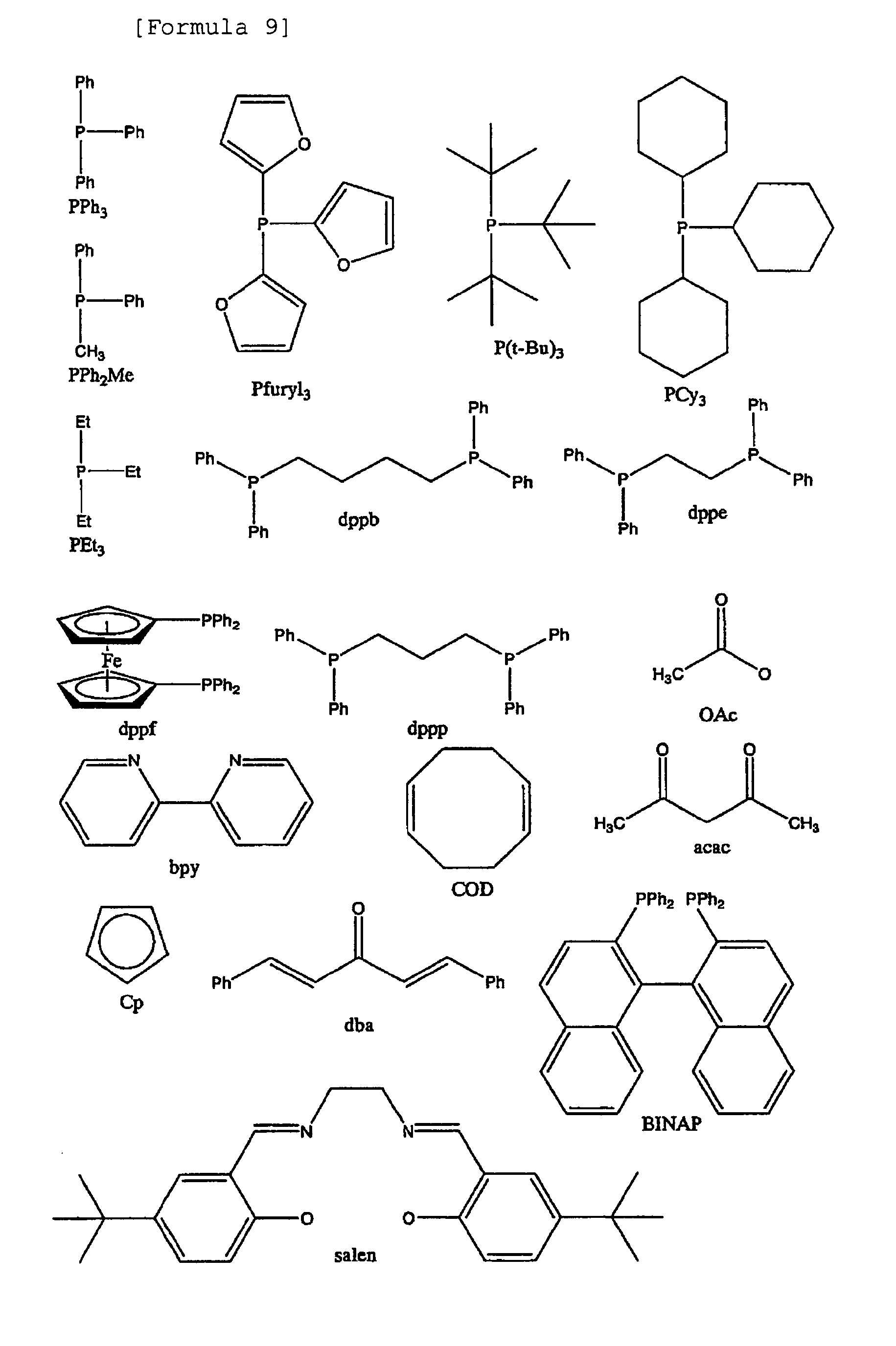

In the formulas, Ph, Et, and t-Bu stand for phenyl group, ethyl group, and tertiary butyl group respectively.

Among them, palladium complexes and the like, which are disclosed in the same literature, and which contain as a ligand phosphines or carbenes, are preferable. A palladium complex is more preferably a palladium complex, which contains as a ligand a phosphine compound, and conspicuously preferably a palladium complex, which contains as a ligand a phosphine compound represented by the undermentioned general formula (III).

P(R¹)₃ (III)

In the formula, three R¹ are same as or different from each other and stand for a group represented by the undermentioned formula (IV) or a group represented by the undermentioned formula (V), but at least one of three R¹ stands for a group represented by the undermentioned formula (IV).

-C(R²)₃ (IV)

In the formula, three R² are same as or different from each other and stand for hydrogen atom or a substituted or unsubstituted hydrocarbon group, but two or more R² do not stand for a hydrogen atom and two R² among three R² may be bonded together to form a ring.

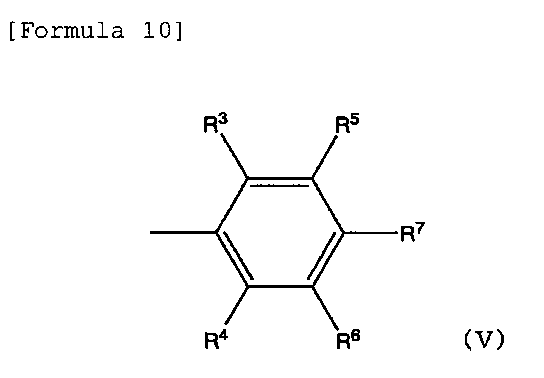

In the formula, R³ to R⁷ independently stand for hydrogen atom, a substituted or unsubstituted hydrocarbon group, a substituted or unsubstituted hydrocarbon oxy group, a substituted or unsubstituted hydrocarbon-disubstituted amino group, a substituted or unsubstituted hydrocarbon mercapto group, a substituted or unsubstituted hydrocarbon carbonyl group, a substituted or unsubstituted hydrocarbon oxycarbonyl group, a substituted or unsubstituted hydrocarbon-disubstituted aminocarbonyl group, or a substituted or unsubstituted hydrocarbon sulfonyl group. At least one of R³ and R⁴ stands for a group other than hydrogen atom. In at least one of the combinations of R³ and R⁵, R⁵ and R⁷, R⁴ and R⁶, and R⁶ and R⁷, the two groups may be bonded together to form a ring.
In the above-mentioned general formula (III), R¹ is a group represented by the above-mentioned formula (IV) or a group represented by the above-mentioned formula (V), three R¹ may be same or different, and at least one of three R¹ is a group represented by the above-mentioned formula (IV).

In the above-mentioned general formula (IV), R² is hydrogen atom or a substituted or unsubstituted hydrocarbon group, three R² may be same as or different from each other, two R² may be bonded together to form a ring, and two or more R² do not stand for hydrogen atom. That is, when R² are not bonded together to form a ring, at least two R² stand for a substituted or unsubstituted hydrocarbon group.
In the above-mentioned general formula (V), R³ to R⁷ independently stand for preferably hydrogen atom, or a substituted or unsubstituted hydrocarbon group.

As a substituted or unsubstituted hydrocarbon group of R² in the above-mentioned general formula (IV), there can be cited the substituted or unsubstituted hydrocarbon groups shown as examples of a substituent of an aromatic ring of Ar in the above-mentioned general formula (I).

As a group of the above-mentioned general formula (IV), t-butyl group, 3-ethyl-3-pentyl group, isopropyl group, isobutyl group, 3-pentyl group, cyclopentyl group, 1-methylcyclohexyl group, and cyclohexyl group are preferable, t-butyl group, cyclopentyl group, and cyclohexyl group are more preferable, and t-butyl group and cyclohexyl group are further more preferable.

As an unsubstituted hydrocarbon group included in a substituted or unsubstituted hydrocarbon group, which can be indicated by R³ to R⁷ in the above-mentioned general formula (V), there can be cited the hydrocarbon groups shown as examples of a substituent of an aromatic ring of Ar in the above-mentioned general formula (I). As the hydrocarbon groups, an alkyl group having 1 to 12 carbon atoms, a cycloalkyl group having 3 to 12 carbon atoms, and an aryl group having 6 to 12 carbon atoms are preferable, an aryl group having 6 to 12 carbon atoms is more preferable, and phenyl group is especially preferable. As substituted hydrocarbon groups, there can be cited those which are formed by replacing such unsubstituted hydrocarbon groups with, for example, fluorine atom, nitro group, cyano group, or the like. Among these substituents, a hydrocarbon oxy group having 1 to 12 carbon atoms, a hydrocarbon-disubstituted amino group having 2 to 12 carbon atoms, and a hydrocarbon mercapto group having 1 to 12 carbon atoms are preferable, and a hydrocarbon oxy group having 1 to 8 carbon atoms, and a hydrocarbon-disubstituted amino group having 2 to 8 carbon atoms are more preferable.

In addition, concrete examples and preferable examples of unsubstituted, hydrocarbon oxy group, hydrocarbon-disubstituted amino group, hydrocarbon mercapto group, hydrocarbon carbonyl group, hydrocarbon oxycarbonyl group, hydrocarbon-disubstituted aminocarbonyl group, and hydrocarbon sulfonyl group, which can be indicated by R³ to R⁷, are as explained as substituents of an aromatic ring of Ar in the above-mentioned general formula (I). The definitions of substituents, which may be replaced on these, are the same as those of substituents, which may be substituted on the above-mentioned substituted or unsubstituted hydrocarbon group, and the preferable examples and concrete examples thereof are also the same.

As R³ to R⁷ in the above-mentioned general formula (V), hydrogen atom, a substituted or unsubstituted hydrocarbon group, a substituted or unsubstituted hydrocarbon oxy group, and a substituted or unsubstituted hydrocarbon-disubstituted amino group are preferable, hydrogen atom, a substituted or unsubstituted hydrocarbon group, and a substituted or unsubstituted hydrocarbon oxy group are more preferable, and hydrogen atom and a substituted or unsubstituted hydrocarbon group are further more preferable.

As concrete examples of a group represented by the above-mentioned general formula (V), there are cited 2-methylphenyl group, 2,6-dimethylphenyl group, 2,4,6-trimethylphenyl group, 2-ethylphenyl group, 2,6-diethylphenyl group, 2-isopropylphenyl group, 2,6-diisopropylphenyl group, 2-t-butylphenyl group, 2-phenylphenyl group, 2,6-diphenylphenyl group, 2-methoxyphenyl group, 2,6-dimethoxyphenyl group, 2,4,6-trimethoxyphenyl group, 2-ethoxyphenyl group, 2,6-diethoxyphenyl group, 2-isopropoxyphenyl group, 2,6-diisopropoxyphenyl group, 2-t-butoxyphenyl group, 2-phenoxyphenyl group, 2,6-diphenoxyphenyl group, 2-(2-methylphenyl)phenyl group, 2-(2,6-dimethylphenyl)phenyl group, 2-(2-ethylphenyl)phenyl group, 2-(2,6-diethylphenyl)phenyl group, 2-(2-isopropylphenyl)phenyl group, 2-(2,6-di-isopropylphenyl)phenyl group, 2-(2-t-butylphenyl)phenyl group, 2-(2-methoxyphenyl)phenyl group, 2-(2,6-dimethoxyphenyl)phenyl group, 2-(2,4,6-trimethoxyphenyl)phenyl group, 2-(2-ethoxyphenyl)phenyl group, 2-(2,6-diethoxyphenyl)phenyl group, 2-(2-isopropoxyphenyl)phenyl group, 2-(2,6-diisopropoxyphenyl)phenyl group, 2-(2-t-butoxyphenyl)phenyl group, 2-(2,6-di-t-butoxyphenyl)phenyl group, and the like. Preferably, there are cited 2-methylphenyl group, 2-ethylphenyl group, 2-isopropylphenyl group, 2-t-butylphenyl group, 2-phenylphenyl group, 2-methoxyphenyl group, 2-ethoxyphenyl group, 2-isopropoxyphenyl group, 2-t-butoxyphenyl group, 2-phenoxyphenyl group, 2-(2-methylphenyl)phenyl group, 2-(2,6-dimethylphenyl)phenyl group, 2-(2-ethylphenyl)phenyl group, 2-(2,6-diethylphenyl)phenyl group, 2-(2-isopropylphenyl)phenyl group, 2-(2,6-di-isopropylphenyl)phenyl group, 2-(2-t-butylphenyl)phenyl group, 2-(2-methoxyphenyl)phenyl group, 2-(2,6-dimethoxyphenyl)phenyl group, 2-(2,4,6-trimethoxyphenyl)phenyl group, 2-(2-ethoxyphenyl)phenyl group, 2-(2,6-diethoxyphenyl)phenyl group, 2-(2-isopropoxyphenyl)phenyl group, 2-(2,6-diisopropoxyphenyl)phenyl group, 2-(2-t-butoxyphenyl)phenyl group, and 2-(2,6-di-t-butoxyphenyl)phenyl group. More preferably, there are cited 2-(2-methylphenyl)phenyl group, 2-(2,6-dimethylphenyl)phenyl group, 2-(2-ethylphenyl)phenyl group, 2-(2,6-diethylphenyl)phenyl group, 2-(2-isopropylphenyl)phenyl group, 2-(2,6-diisopropylphenyl)phenyl group, 2-(2-t-butylphenyl)phenyl group, 2-(2-methoxyphenyl)phenyl group, 2-(2,6-dimethoxyphenyl)phenyl group, 2-(2,4,6-trimethoxyphenyl)phenyl group, 2-(2-ethoxyphenyl)phenyl group, 2-(2,6-diethoxyphenyl)phenyl group, 2-(2-isopropoxyphenyl)phenyl group, 2-(2,6-diisopropoxyphenyl)phenyl group, 2-(2-t-butoxyphenyl)phenyl group, and 2-(2,6-t-butoxyphenyl)phenyl group. Further more preferably, there are cited 2-(2,6-dimethylphenyl)phenyl group, 2-(2,6-diethylphenyl)phenyl group, 2-(2,6-diisopropylphenyl)phenyl group, 2-(2-t-butylphenyl)phenyl group, 2-(2,6-dimethoxyphenyl)phenyl group, 2-(2-ethoxyphenyl)phenyl group, 2-(2,6-diethoxyphenyl)phenyl group, 2-(2,6-diisopropoxyphenyl)phenyl group, and 2-(2,6-di-t-butoxyphenyl)phenyl group.

As preferable concrete examples of a palladium complex, which contains as a ligand a phosphine compound represented by general formula (III), when they are indicated by use of the names of concrete examples of the above ligand, there are cited Pd(PPh₂Me)₂, Pd(P(t-Bu)₃)₂, Pd(PEt₃)₂, Pd(PCy₃)₂, Pd(dppb), Pd(dppe), Pd(dppp), Pd(BINAP), and the like.

The palladium complex used in the present invention, for example, the palladium complex, which contains as a ligand a phosphine compound represented by the above-mentioned general formula (III), can be produced by mixing the phosphine compound and a solubilized Pd(0) complex such as Pd(0)·dibenzylideneacetone complex. It can be also produced by reducing palladium(II) acetate or chloride in the presence of the phosphine compound to produce Pd(0). As examples of a method for producing the palladium complex, there are cited the methods disclosed in Chem. Rev. 102, 1359(2002) and the resource documents thereof. The palladium complexes containing as a ligand a phosphine compound, which have been obtained as a reaction solution by these production methods, may be used as such without isolation for polycondensation or may be isolated and used.

The amount of the phosphine compound used is not limited, but the amount (molar ratio) of the phosphine compound used to palladium(0) is preferably 0.5 to 10, more preferably 0.8 to 5, and further more preferably 0.9 to 3.

The amount of the complex used in the production method of the present invention is not limited, but the amount of the palladium complex to an aromatic compound represented by the above-mentioned general formula (I) is preferably 0.0001 to 10 mole %, more preferably 0.001 to 5 mole %, and further more preferably 0.01 to 5 mole %.

### -Initiating Group-

In the present invention, a substrate insoluble in a reaction solvent has a group represented by the above-mentioned general formula (II). The group represented by general formula (II) functions as an initiating group for allowing an aromatic compound represented by general formula (I) to polycondense in a chain reaction and grow into an aromatic polymer.

X^{a} in general formula (II) is a halogen atom or a group represented by -SO₃Q^{a} wherein Q^{a} stands for a substituted or unsubstituted hydrocarbon group. Herein, the halogen atom stands for fluorine atom, chlorine atom, bromine atom, and iodine atom, and preferably chlorine atom, bromine atom, and iodine atom.

As the substituted or unsubstituted hydrocarbon group represented by Q^{a}, there are cited the hydrocarbon groups and the substituted hydrocarbon groups thereof illustrated as substituents of an aromatic ring. As a substituent of the substituted hydrocarbon group, there is cited, for example, fluorine atom.

As concrete examples of a group represented by -SO₃Q^{a}, there are cited methylsulfo group, phenylsulfo group, p-tolylsulfo group, and trifluoromethylsulfo group.

X^{a} is preferably halogen atom or a group represented by -SO₃Q^{a}, more preferably chlorine atom, bromine atom, iodine atom, or a group represented by -SO₃Q^{a}, and further more preferably bromine atom, iodine atom, or trifluoromethylsulfo group.

Ar^{a} is a group having a valence of p+1 and comprising an aromatic ring. Herein, "group having a valence of p+1 and comprising an aromatic ring" means a residual group having a valence of p+1, which is formed by removing hydrogen atoms respectively bonded to each of different (p+1) atoms, which are carbon atom(s) and/or hetero atom(s), and which are ring-constituting members of one or two or more aromatic rings present in an aromatic cyclic compound. Herein, an aromatic cyclic compound is as illustrated with regard to the group Ar, and the kinds of an aromatic ring, substituents that an aromatic ring may have, the concrete examples and preferable examples thereof, and the like are all as mentioned above.

In general formula (II), the number p of the group X^{a}(s) bonded to Ar^{a} is 1 or more, and from the standpoint of synthesis, preferably 1 to 5, and more preferably 1 to 2. When plural X^{a} are bonded to one Ar^{a}, they may be same as or different from each other. When plural X^{a}s are present, from the standpoint of synthesis, they consist of preferably 1 to 5 kinds of groups, and more preferably 1 to 2 kinds of groups.

As concrete examples of a group represented by the above-mentioned general formula (II), there are cited the following groups.

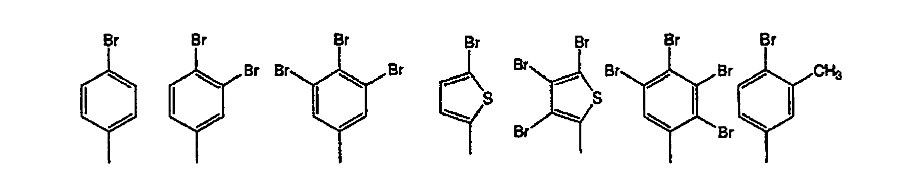

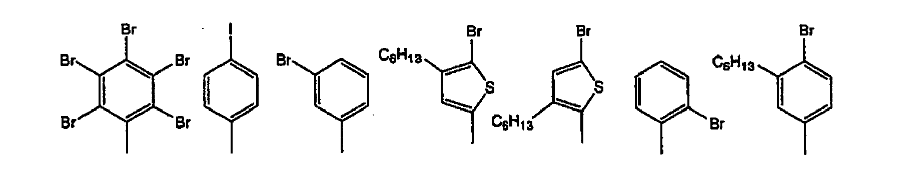

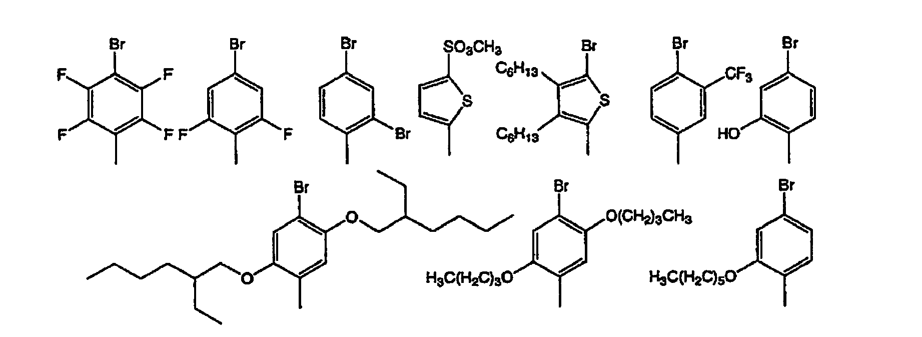

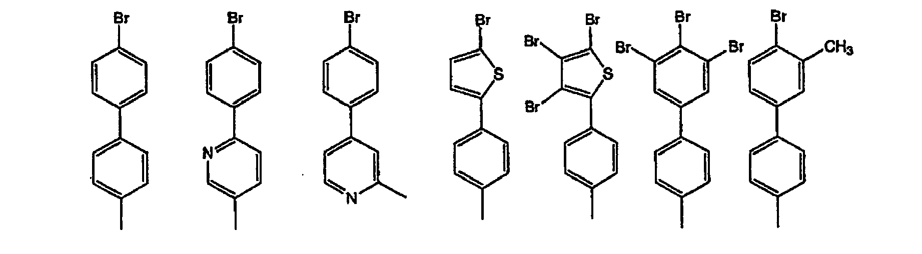

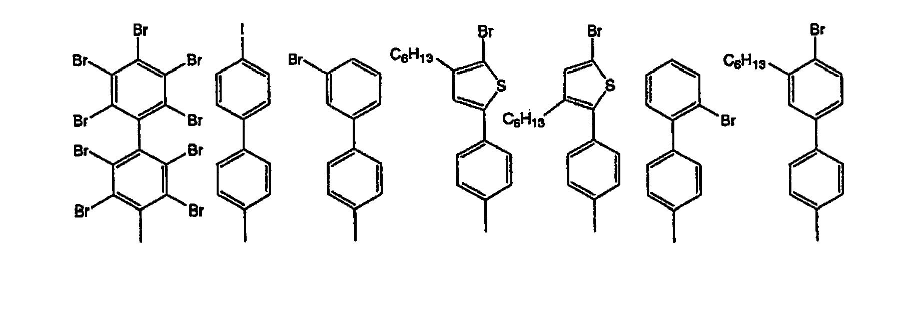

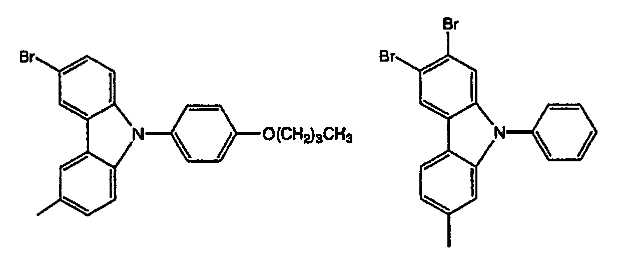

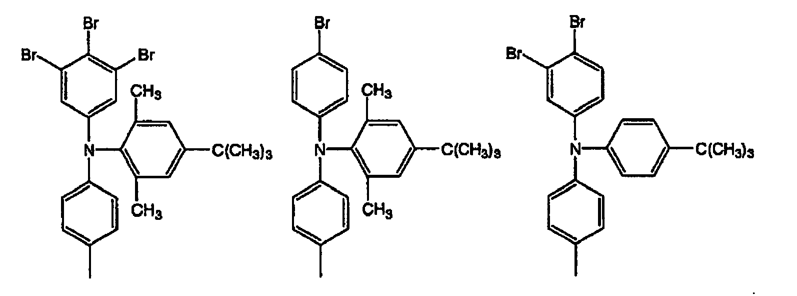

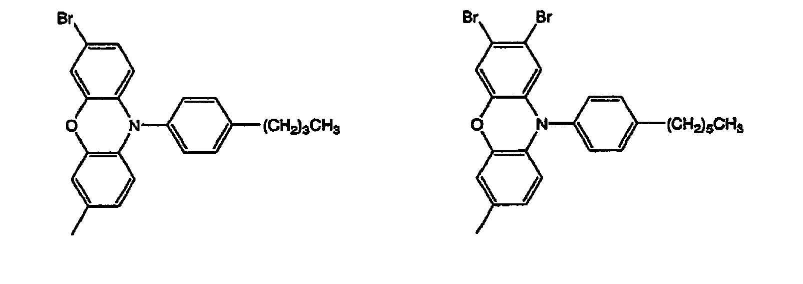

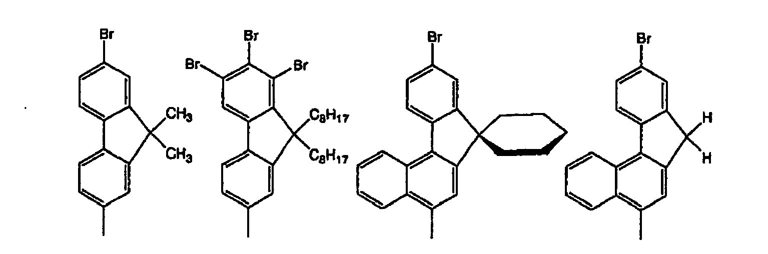

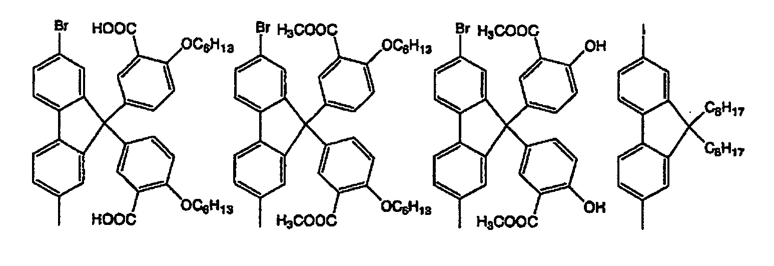

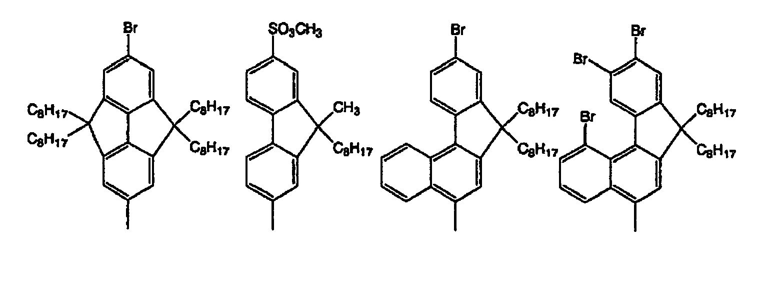

### -Substrate-

In the present invention, a substrate having on its surface a group represented by the above-mentioned general formula (II) is insoluble in a reaction solvent. However, it is not limited in its shape, raw material, and the like, and it may be conductive or non-conductive. That is, the shape can be selected depending on the use, and it may be in the state of plate, sphere, powders, rubber, jelly, or the like. In addition, as the raw material, depending on the use, there can be used those which are publicly known in, for example, electronics industry field, display field, and the like. As the concrete examples thereof, there are cited glass, sapphire, semiconductor (for example, silicon or the like), resin (for example, polystyrene gel or the like), poor metal, noble metal (for example, platinum, gold, palladium, or the like), oxide (for example, silicon oxide, indium tin oxide, tin oxide, titanium oxide, molybdenum oxide, tungsten oxide, tantalum oxide, aluminum oxide, or the like), nitride (for example, silicon nitride, gallium nitride, or the like), carbide (for example, silicon carbide or the like), and the like.

Introduction state of a group represented by general formula (II) to a substrate depends on the structure of the substrate, particularly the surface portion of the substrate. When a substrate is porous and has open-cell structure, depending on a method for introducing a group represented by general formula (II), the group represented by general formula (II) is introduced to not only the surface portion but also the interior portion of the substrate, but such a substrate is not preferable for the method of the present invention. For the method of the present invention, preferable is the substrate whose surface is smooth or has irregularities, or the only surface of which is porous. A group represented by general formula (II), is introduced to a surface containing the inner surfaces of such pores or concave portions. In the present specification, the surface of a substrate is used in the meaning that it contains the inner surfaces of pores or concave portions present in the substrate surface.

Operation for chemically bonding a substrate and a group represented by general formula (II) may be completed prior to the polycondensation or conducted simultaneously with the polycondensation. It is preferable that the operation is completed prior to the polycondensation. The number density of a group represented by general formula (II) on the surface of the substrate is not particularly limited and can be changed depending on the use. From the standpoint of giving function to the surface of the substrate, the number density is preferably 1/µm² to 20/nm², more preferably 200/µm² to 20/nm², and most preferably 100,000/µm² to 20/nm².

As a method for chemically bonding a group represented by general formula (II) to a substrate, there is no particular limitation, and there are cited, for example, a method of treating a substrate with a coupling agent, which comprises a compound having a group represented by general formula (II) and a functional group for producing a chemical bond to the substrate, an electric field polymerization involving cross-linking (Journal of Adhesion Society of Japan, 34(8)311(1998)), and the like. As the above coupling agent, there are cited a silane coupling agent and a thiol type coupling agent (both, cf., for example, the Japanese periodical, Material Technology 14(10)288(1996)), and there can be used commercially available ones. In addition, a group represented by general formula (II) can be chemically bonded to a substrate through radical reaction by use of a compound generating a radical with light and/or heat. As a chemical bond formed to the substrate, any of covalent bond, coordination bond, hydrogen bond, and ionic bond is good, covalent bond or hydrogen bond is preferable, and covalent bond is more preferable for the purpose of forming a strong bond. Desirably, the kind of a functional group is selected suitably depending on not only the kind of the bond formed but also the raw material constituting the substrate and the surface state of the substrate (the kind of a reactive group or the like present on the surface). The number ratio of the functional groups producing chemical bonds to the substrate and the groups represented by general formula (II), which are present in a coupling agent, should be not necessarily 1:1 and may be from 1:100 to 100:1.

As a functional group forming covalent bond or hydrogen bond, there are cited, for example, mercapto group, disulfide bond, hydroxy group, carboxy group, sulfonic acid group, phosphonic acid group, trialkoxysilyl group and trihydroxysilyl group, and chlorocarbonyl group (-COCl, the so-called acid chloride), cyanate group, isocyanate group, chlorine atom, bromine atom, and iodine atom, which are not groups, and covalent bond and/or hydrogen bond are/is formed through reaction with a kind or plural kinds of chemical species present on the substrate surface. In this connection, disulfide bond is often produced by bonding of two mercapto groups and has function of forming covalent bond or hydrogen bond similarly to mercapto group. Among these concrete examples, mercapto group, disulfide bond, trialkoxysilyl group and trihydroxysilyl group are preferable in the point of readily forming covalent bond with the substrate.

As a compound generating a radical, an azo compound, a peroxide, and the like are representative, and in the case of using a light having a large energy such as laser, substituted or unsubstituted hydrocarbons are also effective.

In this connection, three alkoxy groups of a trialkoxysilyl group may be same as or different from each other in the kind(s), and each alkoxy group has usually 1 to 9 carbon atoms and preferably 1 to 4 carbon atoms.

A method for bonding a group represented by general formula (II) to the surface of a substrate by treating a substrate with the above-mentioned coupling agent is explained concretely.

### • Case of Using Silane Coupling Agent:

By coating on a substrate an aqueous solution of a silane coupling agent (for example, bromophenyltrimethoxysilane manufactured by Petrarch Company) having, for example, a trialkoxysilyl group and/or trihydroxysilyl group and a group represented by general formula (II) and drying it, a group represented by general formula (II) (in the case of this example, bromophenyl group) can be introduced to the substrate. This method can be applied to the substrates shown in the above-mentioned concrete examples, and is preferable in the case of using, as a substrate, glass, sapphire, silicon, iron, aluminum, zinc, silicon oxide, indium tin oxide, tin oxide, titanium oxide, molybdenum oxide, tungsten oxide, tantalum oxide, or aluminum oxide, and is particularly preferable in the case of using, as a substrate, glass, silicon, iron, aluminum, zinc, silicon oxide, or indium tin oxide.

### • Case of Using Thiol Type Coupling Agent:

By coating on a substrate an alcohol solution of a thiol type coupling agent (for example, bromobenzenethiol manufactured by, for example, Tokyo Kasei) having mercapto group and a group represented by general formula (II) and drying it, a group represented by general formula (II) (in the case of this example, bromophenyl group) can be introduced to the substrate. This method can be applied to the substrates shown in the above-mentioned concrete examples, and is preferable in the case of using, as a substrate, platinum, gold, palladium, silicon, iron, aluminum, zinc, silicon oxide, indium tin oxide, tin oxide, titanium oxide, molybdenum oxide, tungsten oxide, tantalum oxide, or aluminum oxide, more preferable in the case of using, as a substrate, platinum, gold, palladium, iron, aluminum, zinc, silicon oxide, or indium tin oxide, and particularly preferable in the case of using, as a substrate, gold.

As concrete examples of the above-mentioned silane coupling agent, there are cited the following examples.

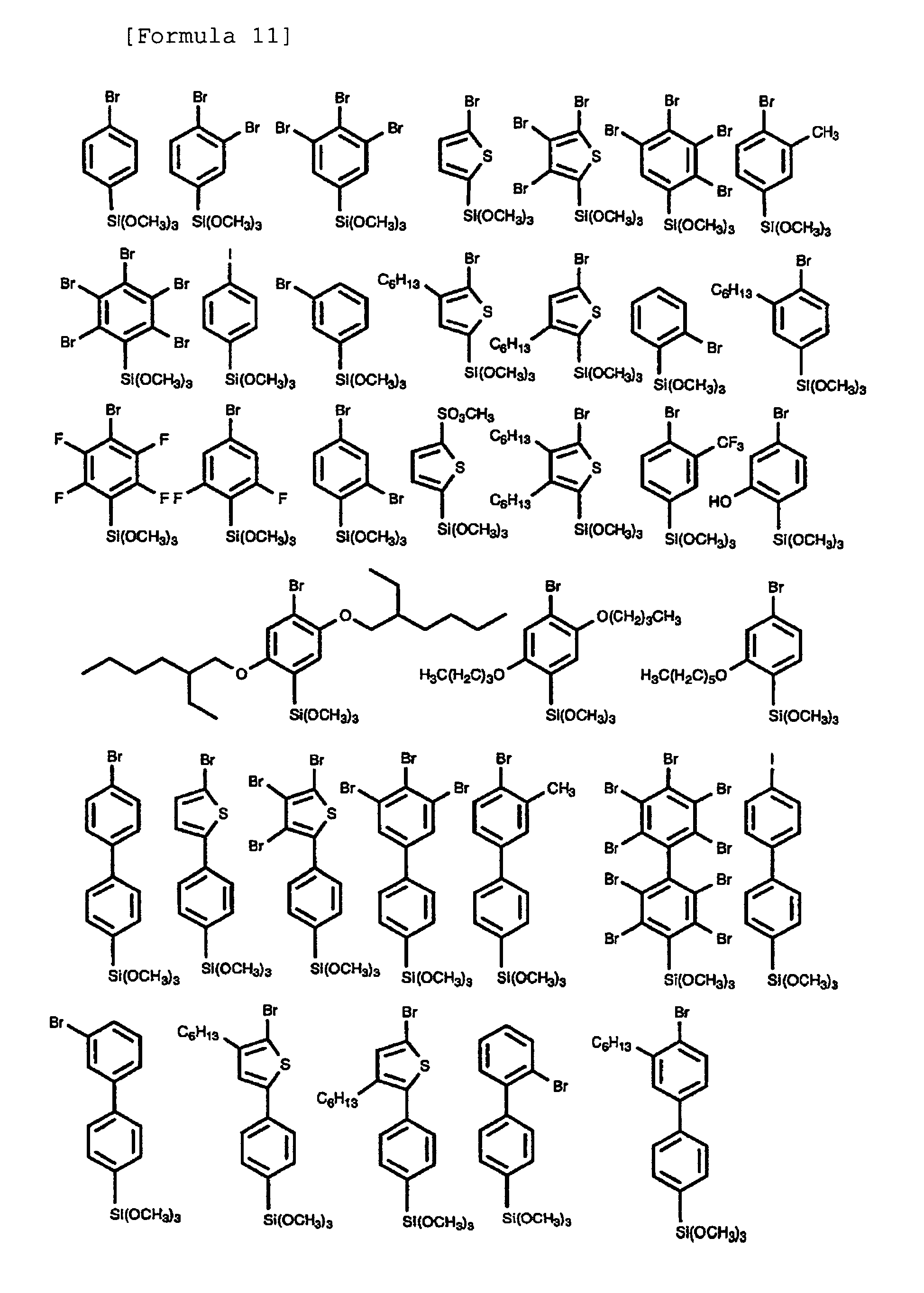

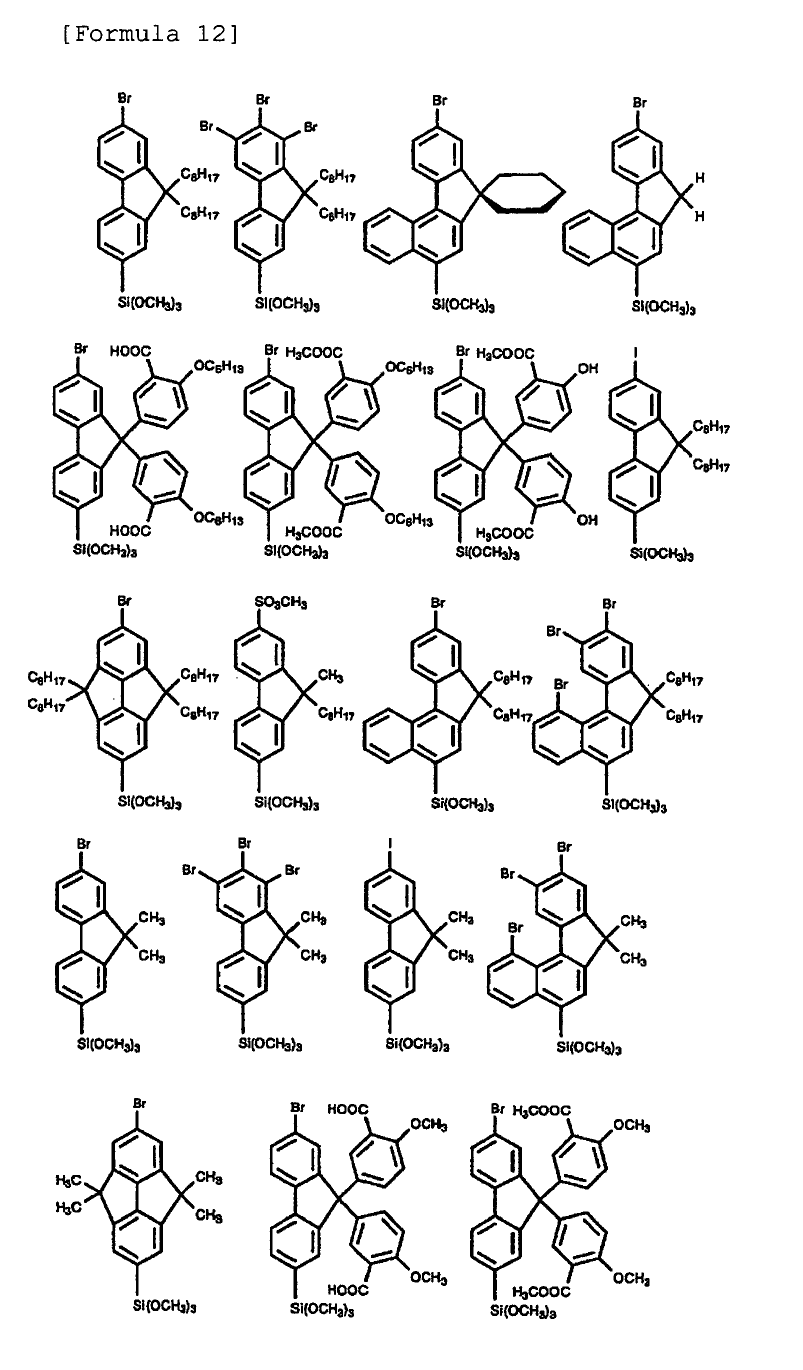

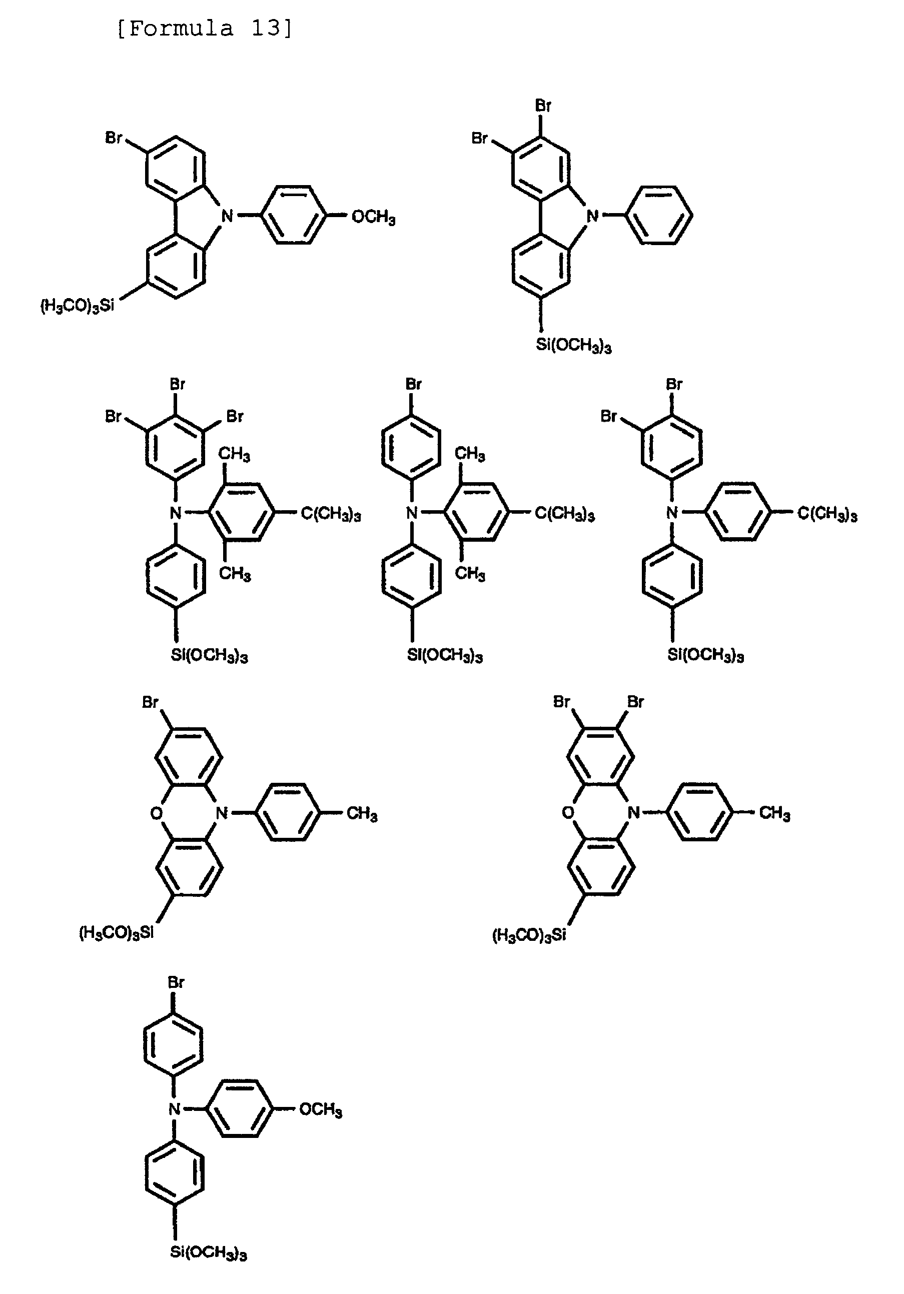

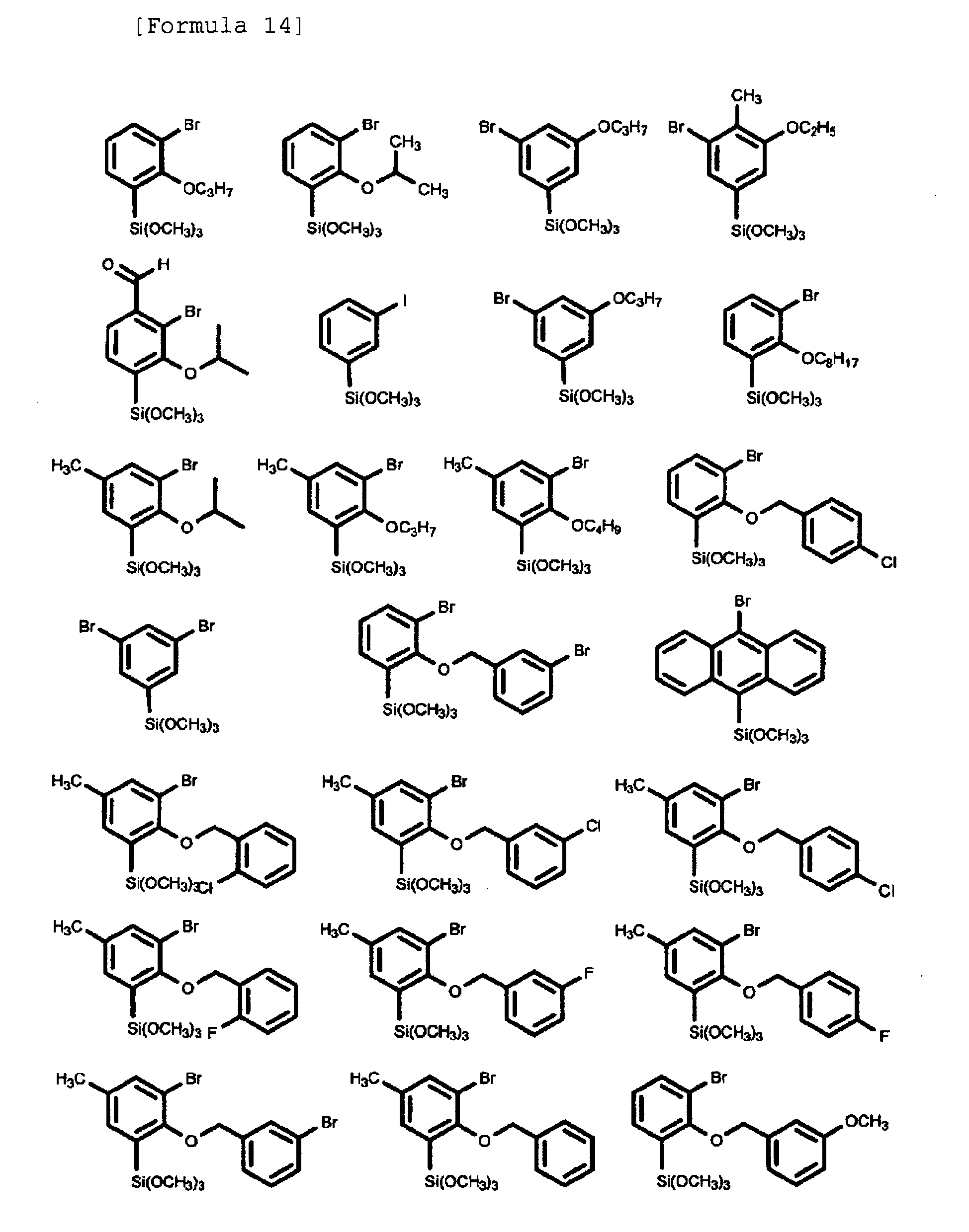

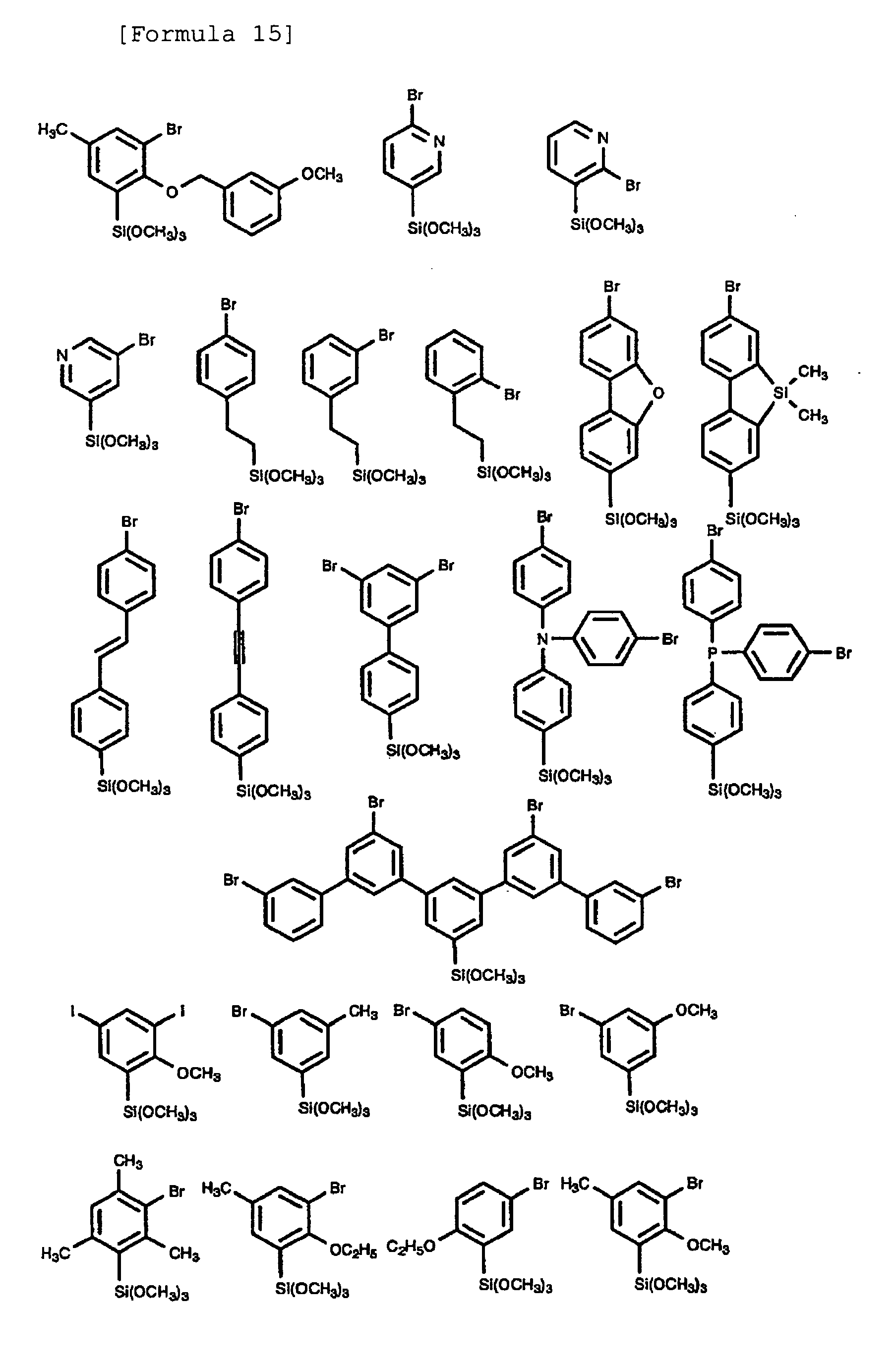

As concrete examples of the above thiol type coupling agent, there are cited the following examples.

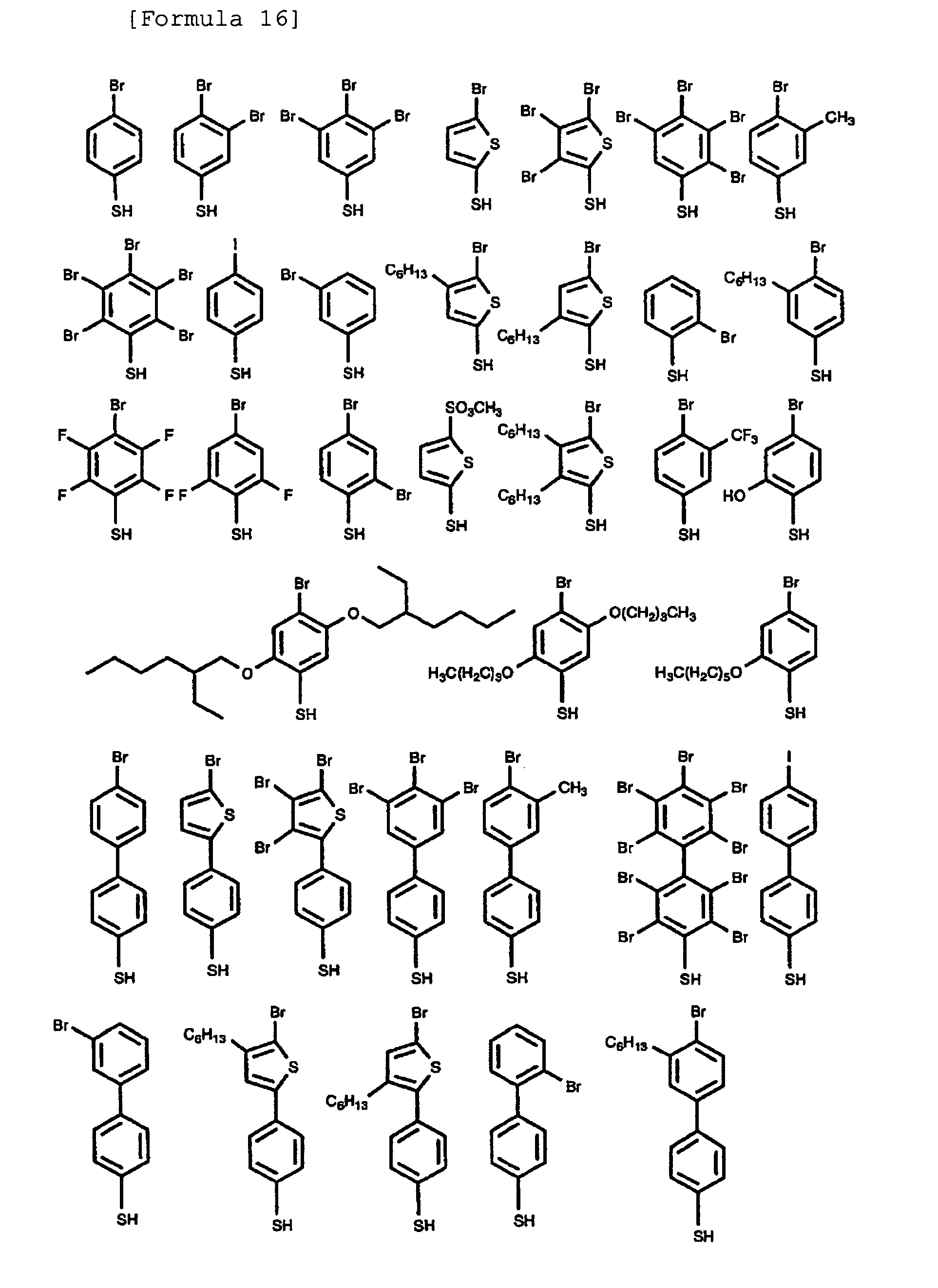

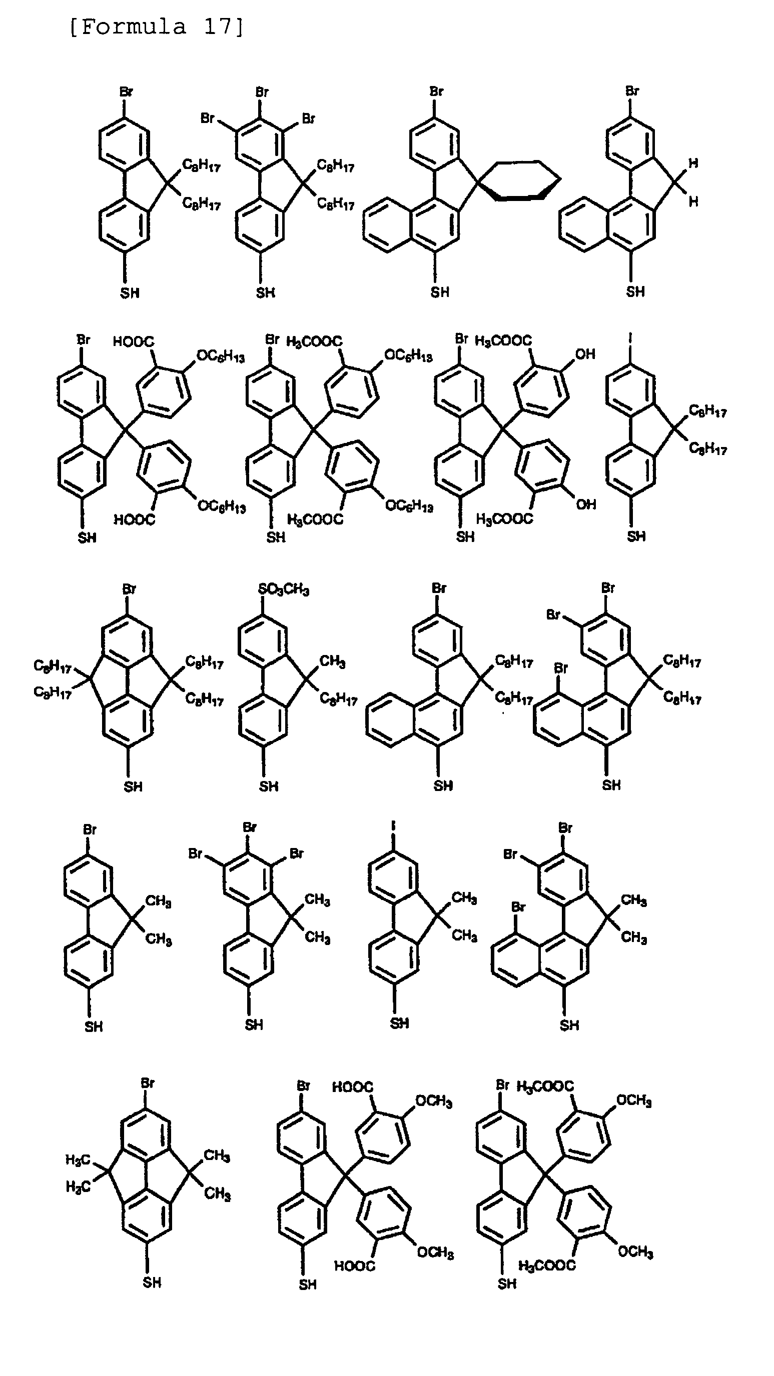

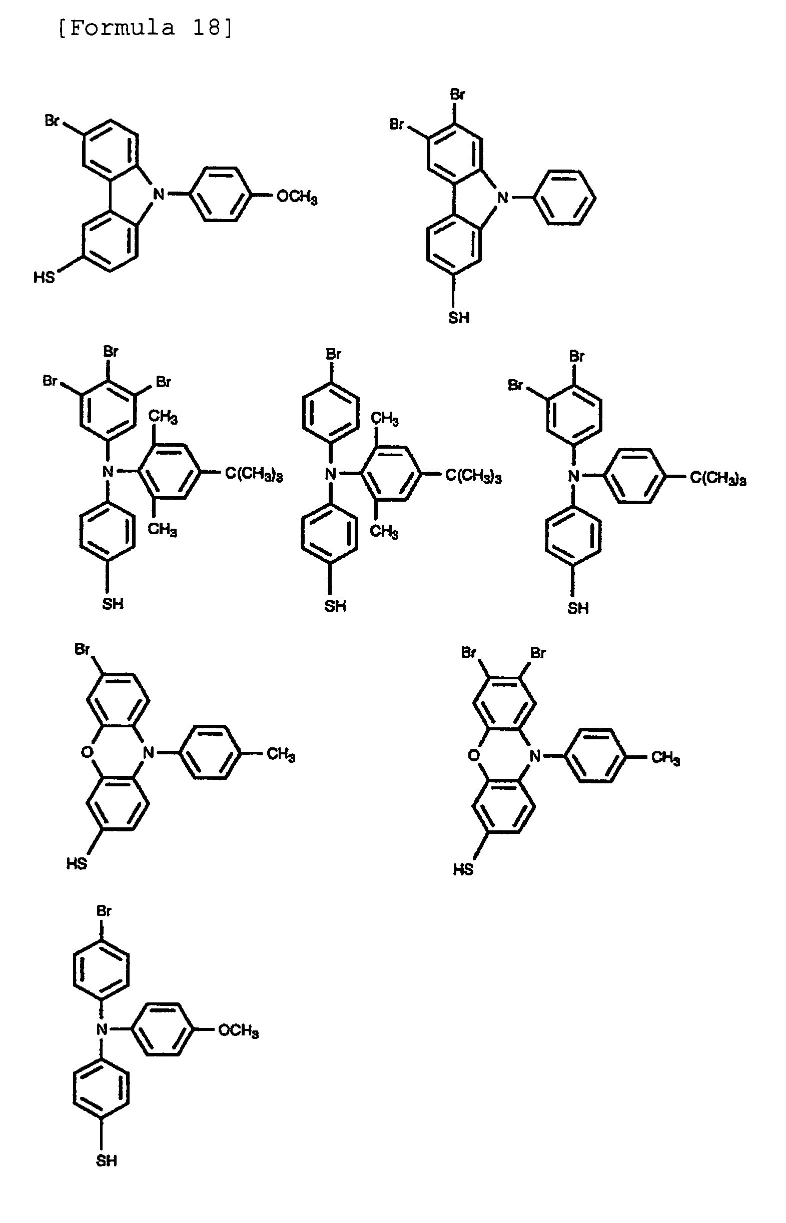

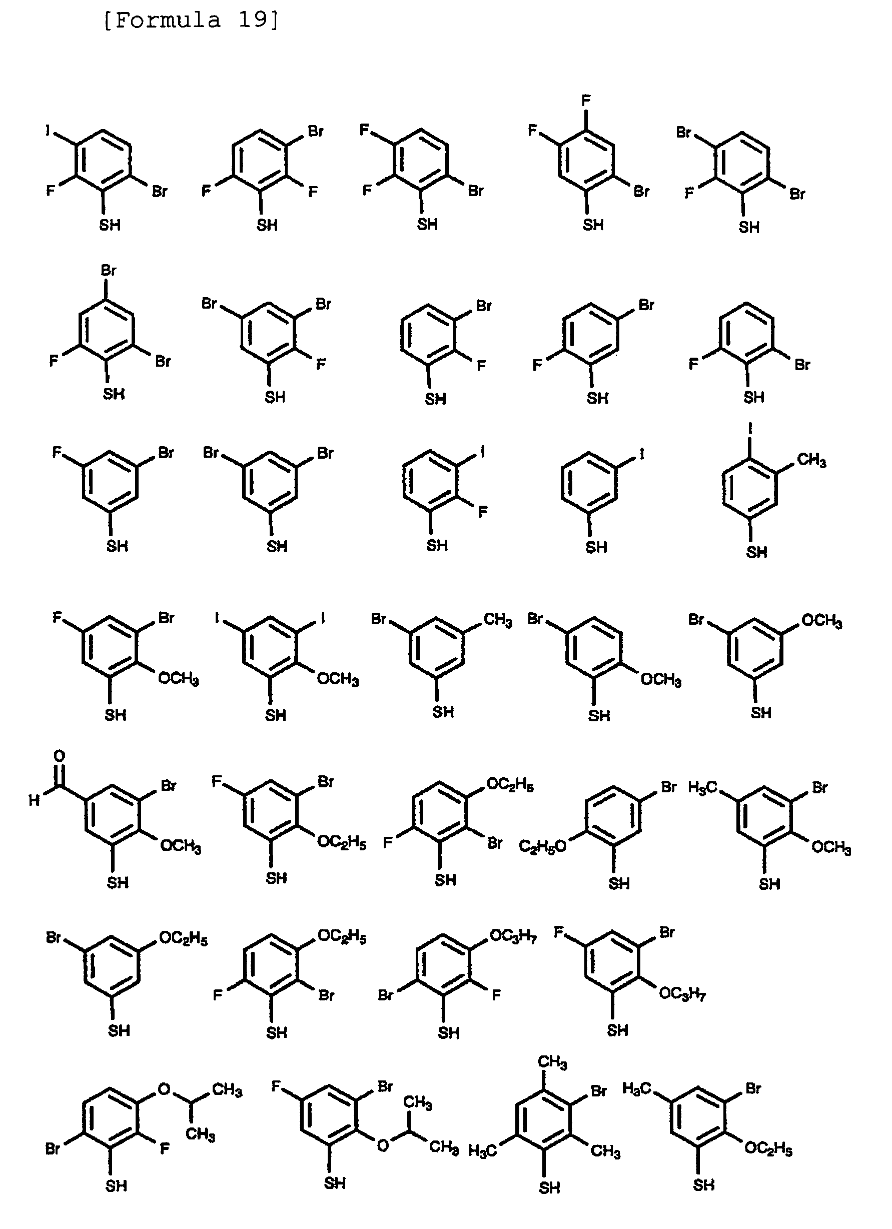

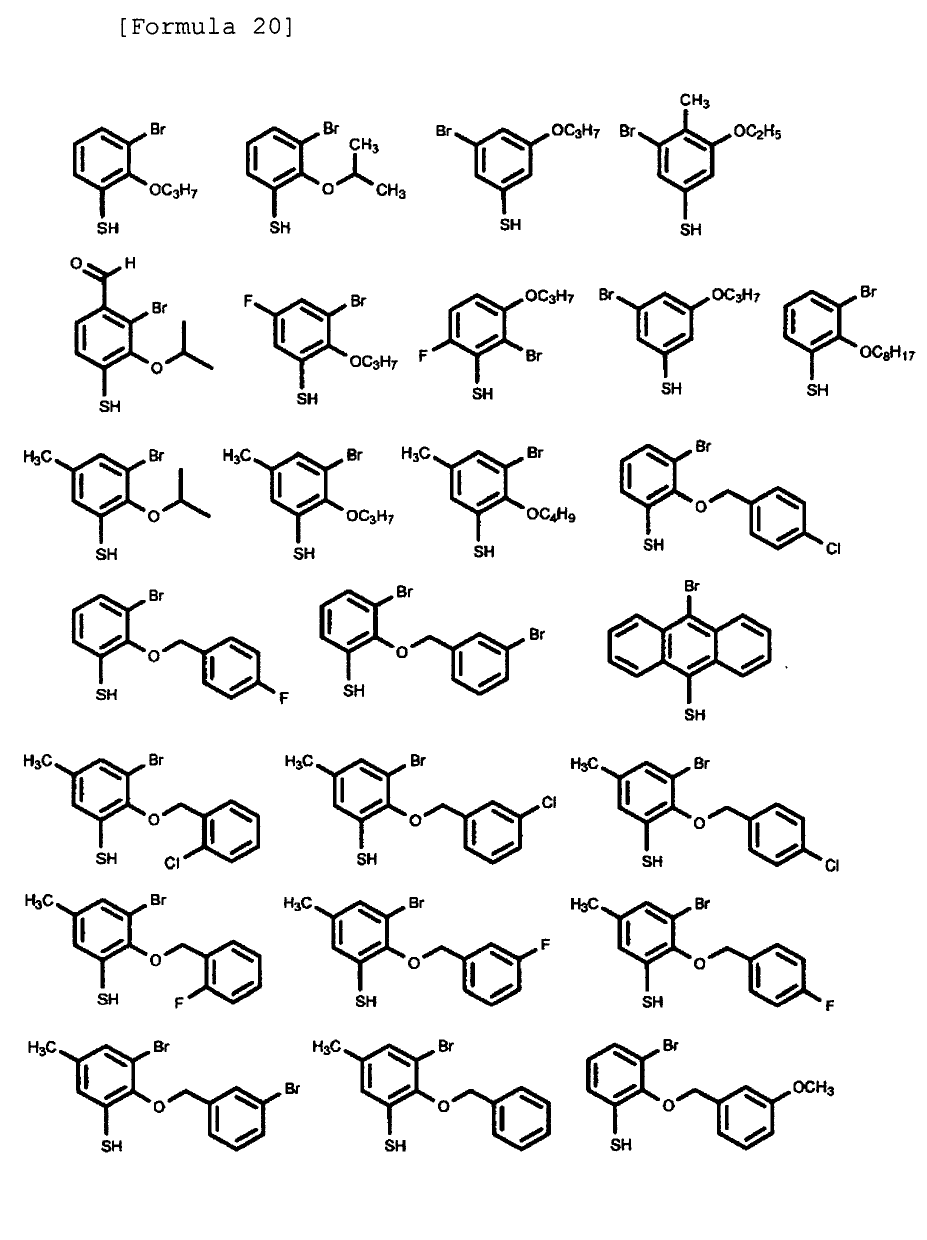

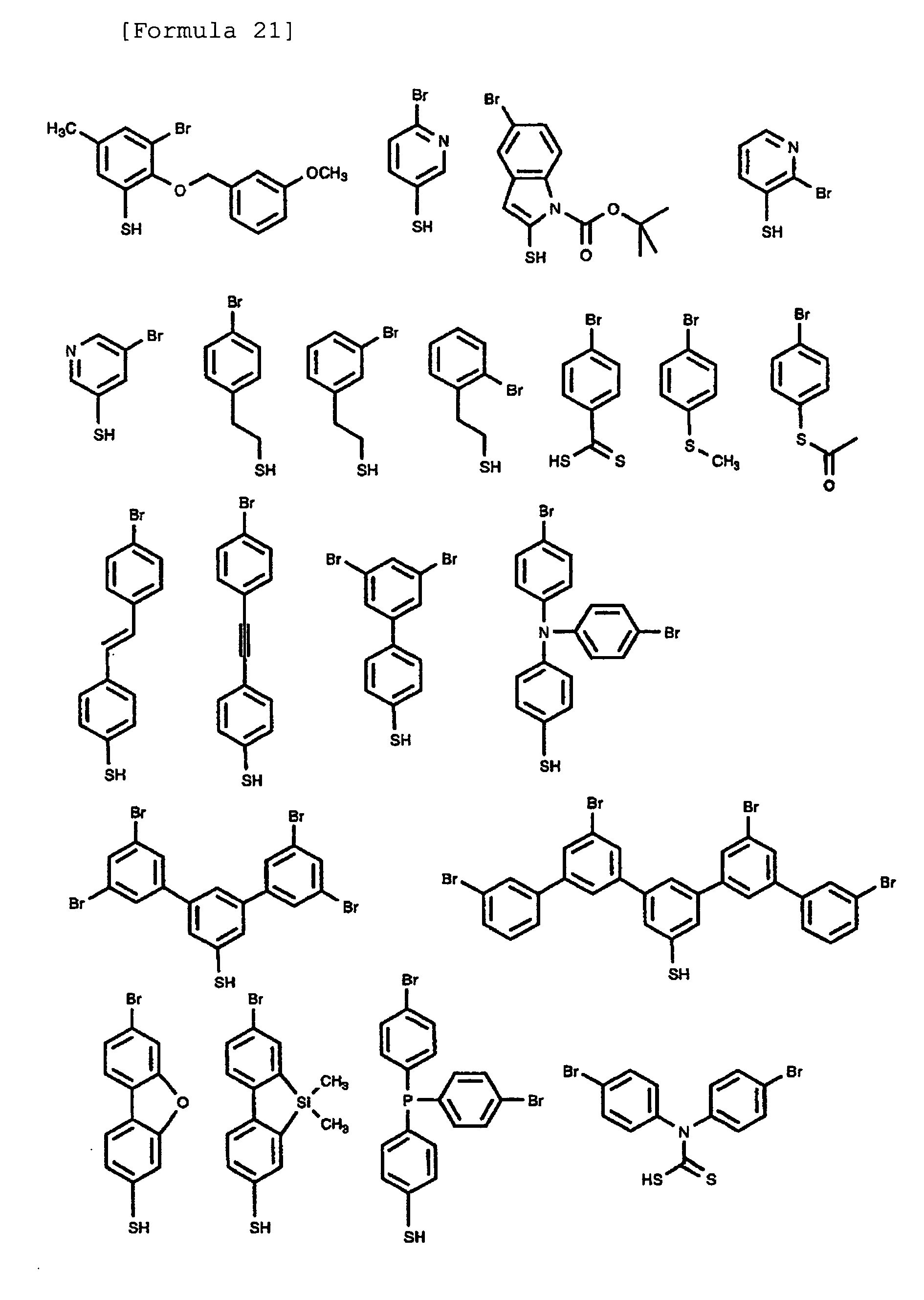

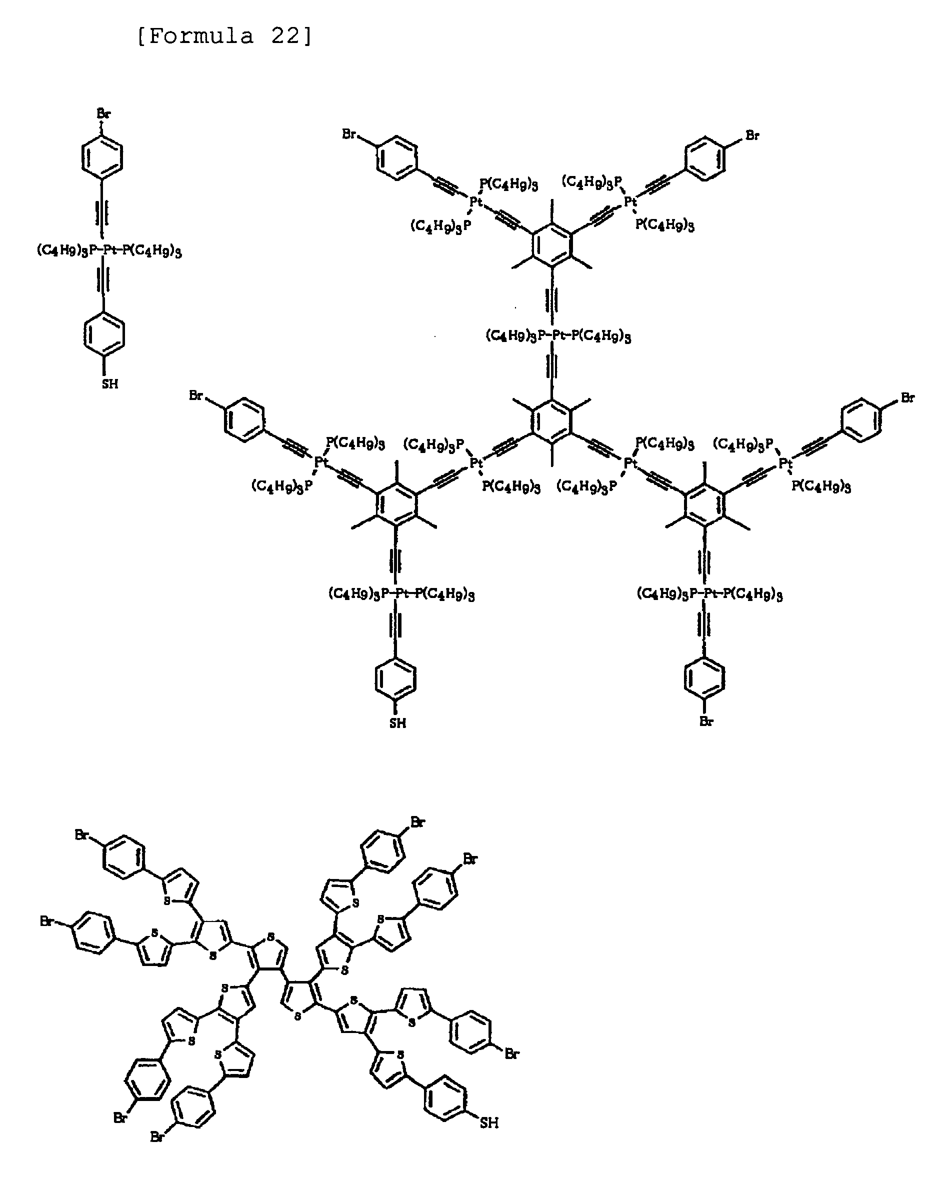

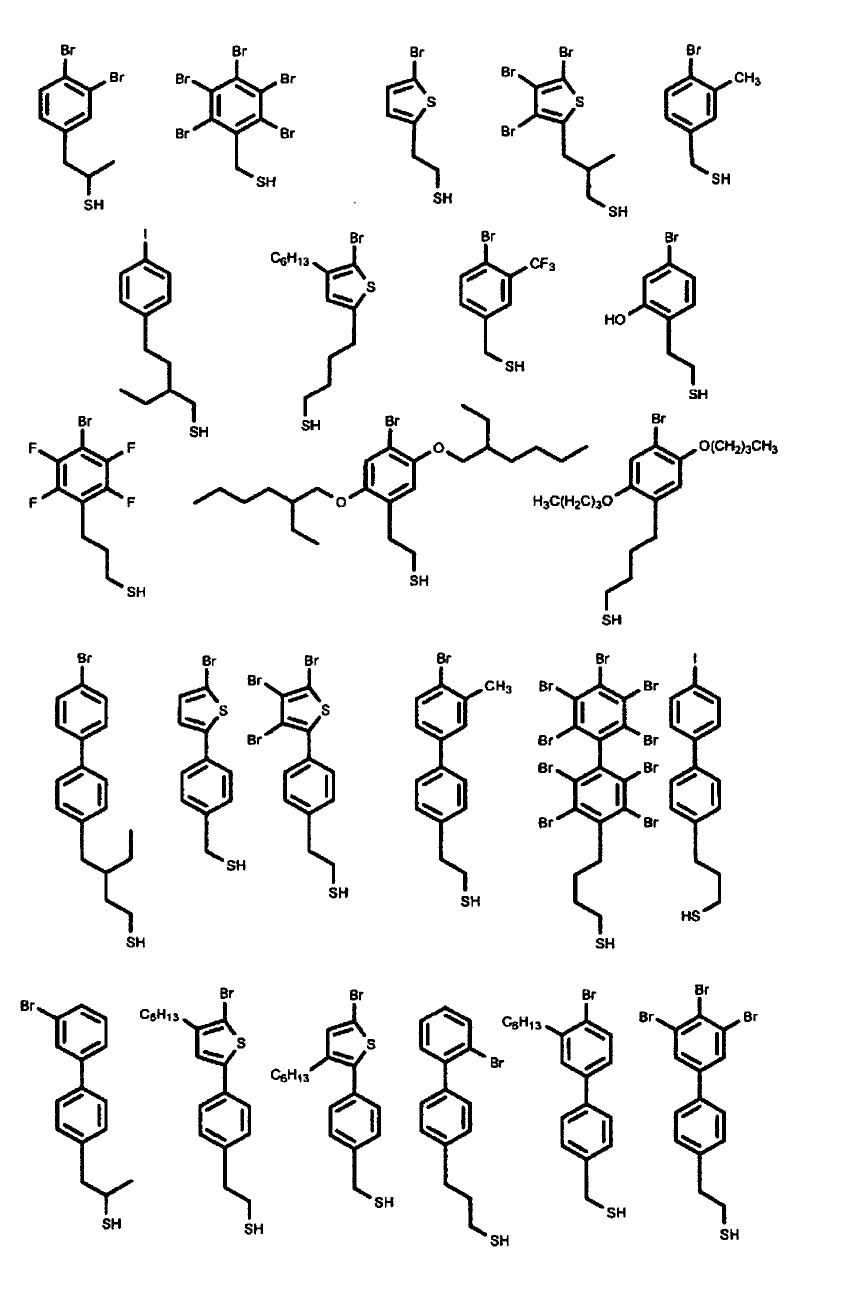

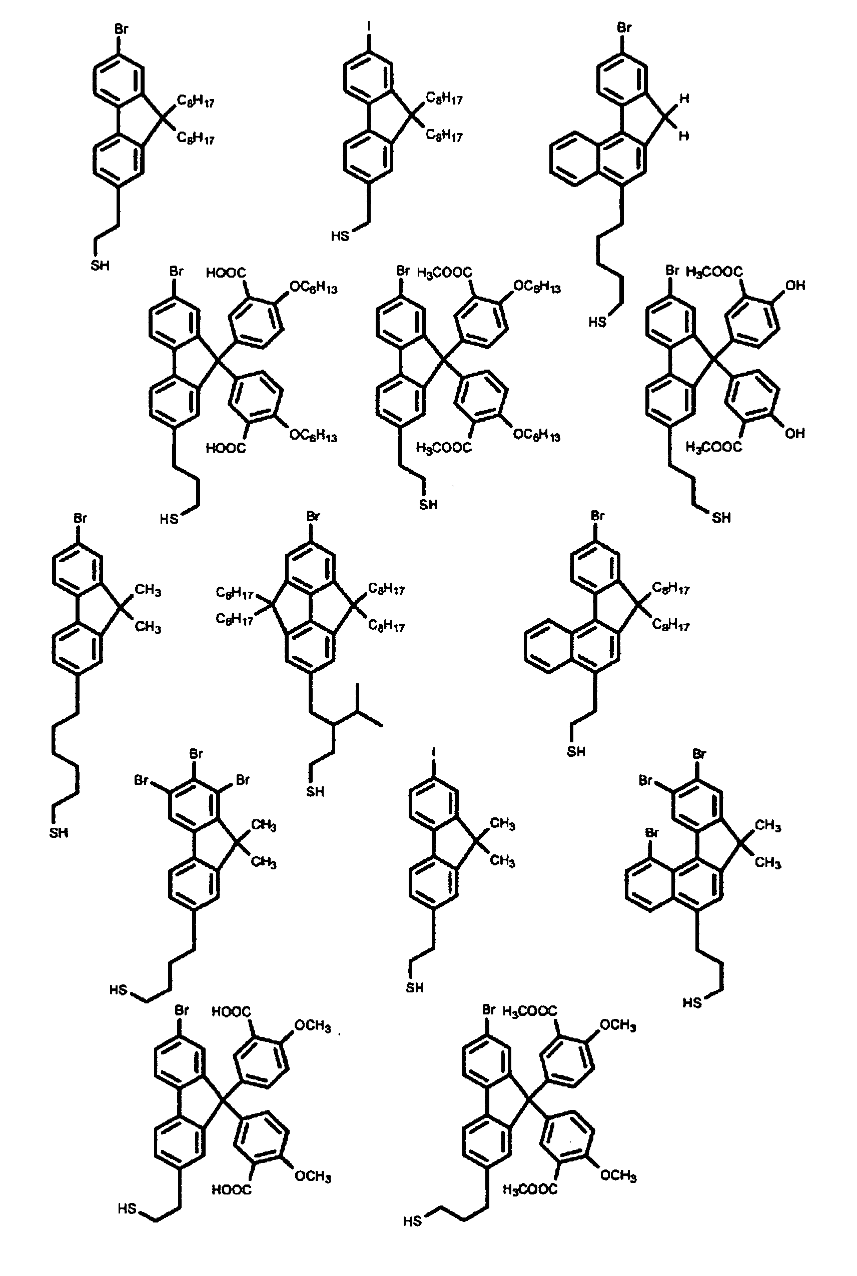

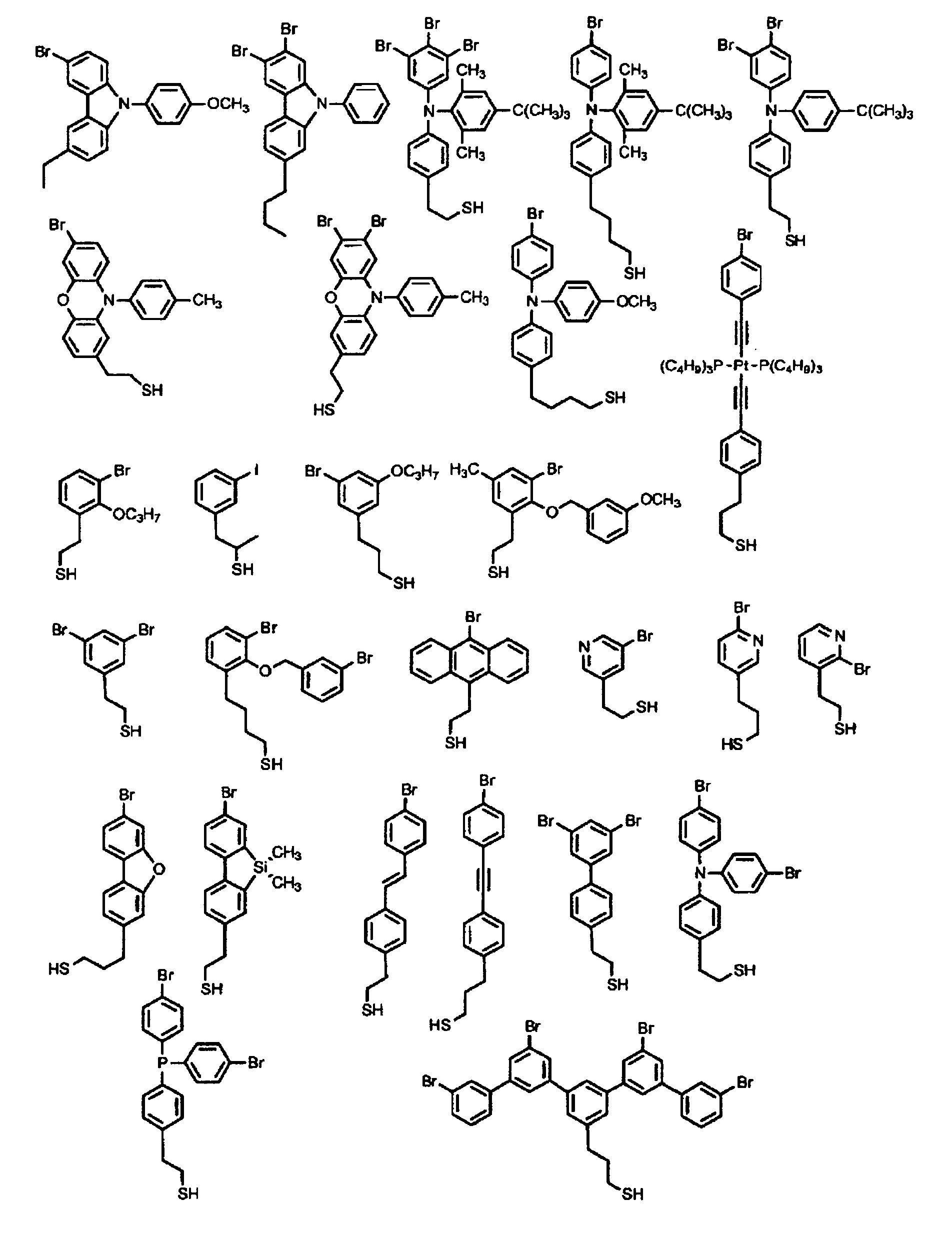

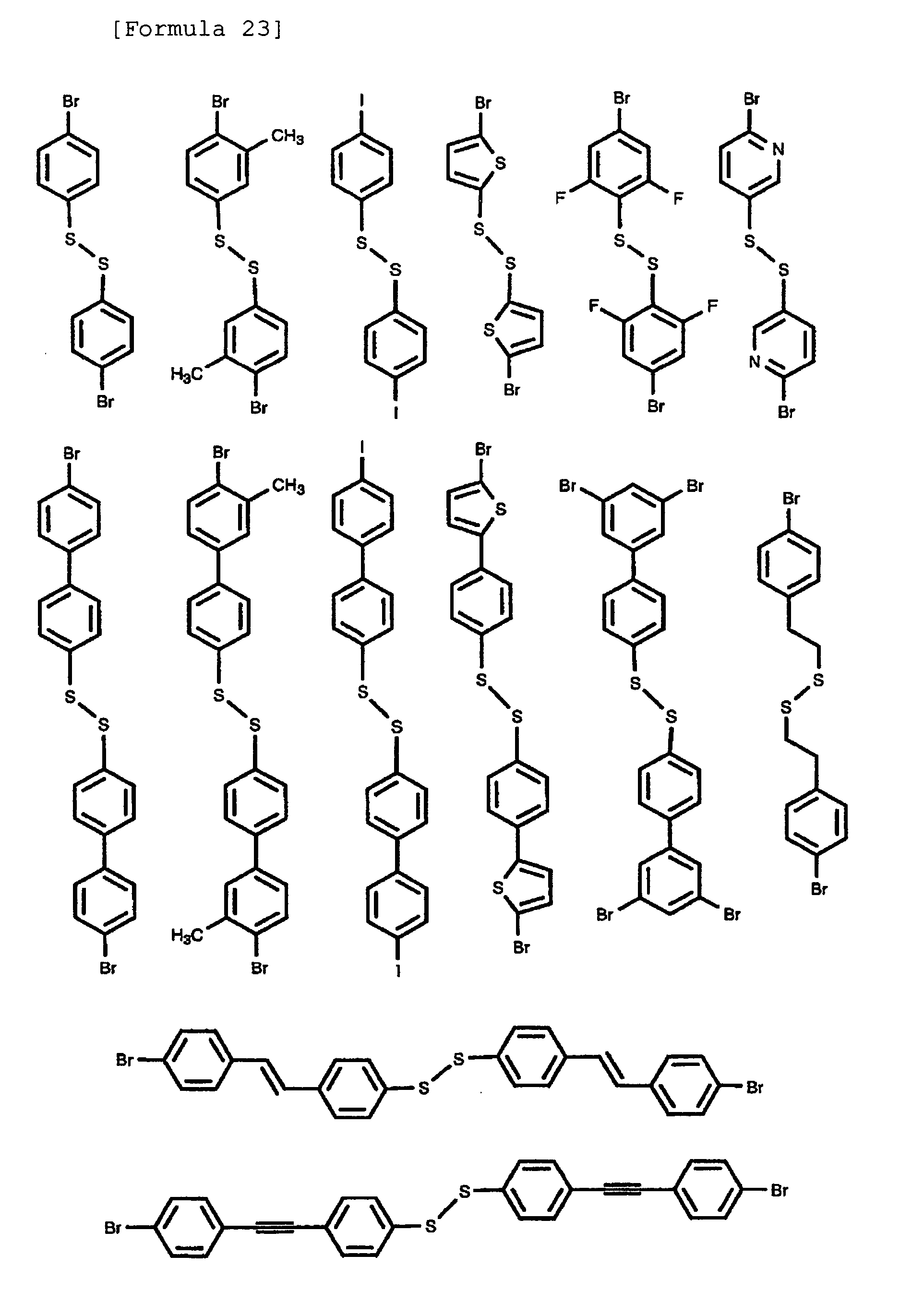

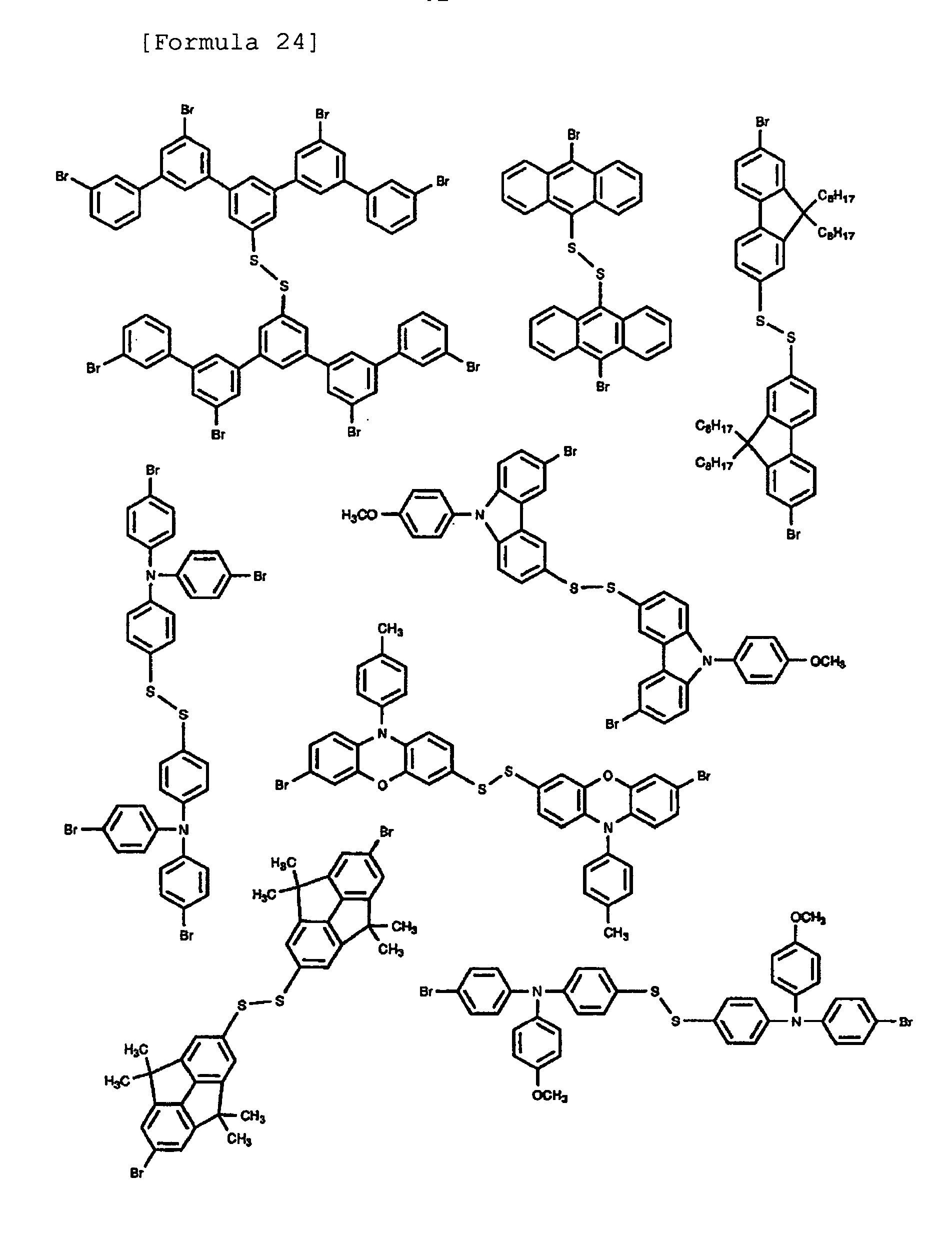

When p=1 in general formula (II), an aromatic polymer thus obtained by the method of the present invention is in the form of a single straight chain, and is bonded to the above-mentioned substrate at the one terminal thereof. In addition, when p≥2, there are obtained p straight polymer chains, which are branched at Ar^{a} and extended.

### -Reaction Solvent-

In the method of the present invention, polycondensation is carried out in a solvent. The solvent used is not limited generally, but it is preferable to select an organic solvent, in which the substrate used is insoluble, and by which the substrate is not impaired. As a usable solvent, there are cited, for example, aromatic hydrocarbons such as benzene, toluene, xylene and the like; chain and cyclic aliphatic hydrocarbons such as heptane, cyclohexane and the like; halogenated hydrocarbons such as chlorobenzene, dichlorobenzene, dichloromethane and the like; nitriles such as acetonitrile, benzonitrile and the like; alcohols such as methanol, ethanol, n-propyl alcohol, iso-propyl alcohol and the like; ethers such as dioxane, tetrahydrofuran, ethylene glycol dimethyl ether, and the like; amides such as N,N-dimethylformamide, N-methylpyrrolidone and the like; nitro compounds such as nitromethane, nitrobenzene and the like; and water. As a reaction solvent, preferable are aromatic hydrocarbons, halogenated hydrocarbons, nitriles, ethers, nitro compounds or water. These reaction solvents may be used solely or as a mixture of two or more kinds.

### -Preferable Reaction Conditions-

In the method of the present invention, an aromatic compound represented by the above-mentioned general formula (I) is polycondensed in a solvent in the presence of a polymerization catalyst and a substrate having a group represented by general formula (II).

As reaction conditions for the polycondensation, there can be used various reaction conditions for aromatic coupling using a palladium complex as the above-mentioned polymerization catalyst, which are disclosed in Chem. Rev. 102, 1359(2002) and the resource documents thereof. Particularly, a reaction using an aromatic hydrocarbon wherein M is - B(OQ¹)₂ in the above-mentioned general formula (I), is the representative reaction called as Suzuki coupling, which is disclosed in Chem. Rev. 95, 2457(1995) and the resource documents thereof, and is the reaction condition, which is preferable also in the method of the present invention. It is explained below.

Desirably polycondensation is carried out in the presence of a base. As concrete examples of a base, there are cited hydroxide salts, carbonates, phosphates, and fluoride salts, the counter cations of which are selected from lithium ion, sodium ion, potassium ion, cesium ion, and tetraalkylammonium ion. Particularly, sodium hydroxide, potassium hydroxide, sodium carbonate, potassium carbonate, and cesium carbonate are preferable.

The amount of the base used is not limited but is preferably 0.01 to 1000 moles, more preferably 0.1 to 100 moles, and further more preferably 1 to 30 moles per mole of an aromatic compound represented by the above-mentioned general formula (I).

The polycondensation using Suzuki coupling is carried out in a solvent. The usable solvent is generally as mentioned above.

The amount of the reaction solvent used is usually 0.01 to 10,000 mL, preferably 0.1 to 1,000 mL, and more preferably 1 to 200 mL per g of an aromatic compound represented by the above-mentioned general formula (I).

The reaction temperature of the polycondensation using Suzuki coupling is usually -100°C to +200°C, preferably -50°C to +150°C, and more preferably -20°C to +100°C. The reaction time is usually 0.1 minute to 1,000 hours, preferably 1 minute to 500 hours, and more preferably 10 minutes to 200 hours.

As the after-treatment of the polycondensation using Suzuki coupling, preferably the substrate is taken out from the reaction solution after completion of the reaction, when needed, washed with an organic solvent, aqueous hydrochloric acid solution, water, and the like, and dried to obtain the substrate, to which an aromatic polymer is bonded.

When Suzuki coupling is used in the method of the present invention, as a polymerization catalyst there is used a palladium complex containing as a ligand a phosphine compound represented by the above-mentioned general formula (III). An aromatic polymer obtained in the state of being bonded to a substrate has a structure represented by the undermentioned general formula (VI), and in the general formula the left terminal of the structure corresponds to the state of being bonded to the substrate. The number of groups represented by general formula (II) as an initiating group is constant, and from each initiating group each polymer chain grows in a chain reaction, and therefore there can be obtained an aromatic polymer having a narrower molecular weight distribution.

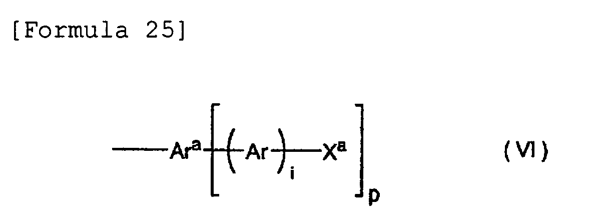

In the formula, Ar, Ar^{a}, X^{a} and p are as defined above, and i is a number average polymerization degree of the repeating configuration Ar.

In the aromatic polymer chain represented by the above general formula (VI) thus obtained, X^{a} is replaced by hydrogen atom in some cases through the polymerization side reaction or after-treatment reaction.

Under the above-mentioned reaction conditions, firstly a palladium complex and a group represented by general formula (II) are presumed to react with each other to produce a group having palladium complex structure represented by the undermentioned general formula (VII), and secondly polymerization is presumed to be initiated from the group represented by general formula (VII), and an aromatic compound represented by the above-mentioned general formula (I) is presumed to polycondense in a chain reaction to produce an aromatic polymer chain of the structure represented by general formula (VI).

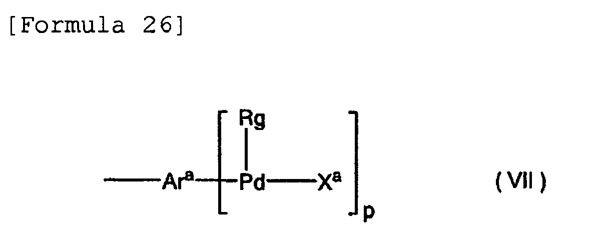

In the formula, Ar^{a}, X^{a} and p are as defined above, and Rg is a ligand such as phosphine, carbene, or the like, preferably a phosphine ligand, and more preferably a phosphine compound represented by the above-mentioned general formula (III).

### <Structure Having Conductive Substrate and Aromatic Polymer Chains>

In description of a method for producing the above-mentioned structure, those having a conductive substrate, are useful particularly as a construction material or constituent element for an electronic device.
Thus, the present invention provides, particularly a structure having a conductive substrate and aromatic polymer chains having the structure represented by the above-mentioned general formula (VI), which are bonded to the conductive substrate.

In the present structure, aromatic polymer chains have the one terminal sides bonded to the above substrate and the other terminal sides in free state, and furthermore are usually bonded to countless bonding sites present on the substrate surface. Therefore, it can be likened to the state of grassland wherein countless grasses grow up on the ground, and polymer chains are in the state of a layer having a thickness. The thickness of this polymer layer, that is, the average length of the whole aromatic polymer chains formed becomes various depending on reaction conditions. In addition, even in the aromatic polymer chains obtained under specific conditions, the lengths of the individual polymer chains are not uniform, but as an intermediate value between the longest polymer chain and the shortest polymer chain, the range of 0.1 nm to 10 cm is preferable, the range of 0.5 nm to 1 mm is more preferable, the range of 1 nm to 100 µm is further more preferable, and the range of 5 nm to 1 µm is conspicuously preferable, from the standpoints of reaction easiness at the time of production and functionality of the structure.

In the structure of the present invention, the configurations of the above-mentioned substrate and the resultant polymer chains may be changed chemically and physically by further processing during the above-mentioned reaction or after the reaction.

### <Electronic Device>

The present structure having a conductive substrate is useful as a construction material or constituent element for an electronic device as mentioned above.
Thus, the present invention provides an electronic device comprising a structure having a conductive substrate and aromatic polymer chains having the configuration represented by the above-mentioned general formula (VI), which are bonded to the conductive substrate.

As the electronic device of the present invention, there are cited, for example, those containing as constituent elements an electrode and an organic substance, and concretely there can be cited luminescent device, photoelectric conversion device, transistor device, capacitor device, piezo-electric device, and the like.
For the electronic device of the present invention, there can be used a constitution containing the above-mentioned structure, more concretely a constitution substituting the structure of the present invention for a portion of multilayer configuration of a publicly known electronic device having multilayer configuration of organic substances. That is, when needed, in addition to the structure, it may have a layer such as anode, cathode, positive hole transport layer, electron transport layer, positive hole injection layer, electron injection layer, positive hole stopping layer, electron stopping layer, luminescent layer, buffer layer, and the like.

The configuration of the electronic device of the present invention is not particularly limited. In one working embodiment of the electronic device of the present invention, an electron transport layer and a cathode metal are laminated in the order on the structure produced by use of a substrate consisting of, for example, indium tin oxide. Herein, when the structure or the material constituting the electron transport layer contains a partial configuration having luminescence function, the electronic device can be used as a luminescent device. The electronic device of the present invention can be used for a luminescent device and a photoelectric conversion device. Also with regard to these devices, there can be used a constitution substituting the structure of the present invention for a portion of multilayer configuration of a publicly known luminescent device or photoelectric conversion device having multilayer configuration of organic substances.

### Examples

Hereinafter, the present invention is illustrated in more detail on the basis of working examples, but the present invention should not be limited in its scope by these working examples.

### <Example 1>

### (i) Synthesis of Bromo Group-Containing Polystyrene Gel

To 1.00 g (5.46 mmol) of 4-bromostyrene, were added 36 mg (0.27 mmol) of 1,4-divinylbenzene, 18 mg (0.11 mmol) of 2,2'-azobis(isobutyronitrile), and 2.0 mL of toluene, and they were agitated at 80°C for 220 minutes under argon atmosphere and cooled to room temperature. The resultant gel was ground in a mortar, swollen with chloroform, and precipitated in 150 mL of methanol. The resultant precipitate was collected through filtration, washed with methanol, and dried in a vacuum to obtain 576 mg (yield 57%) of white powders (a), which were used as a substrate.

### (ii) Introduction of Pd Complex to Bromo Group-Containing Polystyrene Gel

To 1.6 mL of toluene were added 0.20 g (Br group 1.1 mmol) of the powders (a) obtained in (i) and 1.12 g (2.2 mmol) of Pd(P(t-Bu)₃)₂, and they were agitated at 70 °C for 3 hours and cooled to room temperature. The resultant precipitate was collected through filtration, washed with toluene, dried, and moved to a filter for Soxhlet extraction. By conducting Soxhlet extraction (100 °C) with tetrahydrofuran (THF) for 2 hours, the powder on the filter were taken out as much as possible and dried in a vacuum to obtain 180 mg of powder (b).

### (iii) Chain Polycondensation on Gel Surface Wherein Pd Complex Is Introduced

To 89.7 mg of the powder (b) obtained in (ii) were added 4.5 mL of THF and 11.5 mL of 2M aqueous Na₂CO₃ solution, and then the air in the system was replaced with argon gas. Thereto was added a THF (4.5 mL) solution of 330.8 mg of 2-bromo-9,9-dioctylfluorene-7-boronic acid catechol ester, and they were agitated at room temperature for 2 hours and 20 minutes. The resultant precipitate was collected through filtration, then washed with THF, and air-dried. The resultant powder were subjected to Soxhlet extraction with chloroform for 4 hours (100 °C) to become a structure (solid) having a substrate and an aromatic polymer bonded to the substrate. The solid after the extraction was collected as much as possible and dried (60 °C) in a vacuum to obtain 98.4 mg of powder (c).

### <Comparative Example 1>

### (iv) Yamamoto Polymerization Comparative Experiment

Sixty nine mg (0.12 mmol) of 2,7-dibromo-9,9-dioctylfluorene were mixed with 36 mg (0.23 mmol) of 2,2'-bipyridyl and 20 mg of the above-mentioned powder (a), and the system was replaced with argon gas, and then 4.5 ml of THF was added thereto, and they were agitated at 60 °C for 5 minutes, and thereto were added 62 mg (0.22 mmol) of bis(1,5-cyclooctadiene)nickel. They were agitated at 60 °C for 2 hours and then cooled to room temperature, and thereto were added 2 drops of 35 % hydrochloric acid with a pipette while stirring, and then the resultant precipitate was collected through filtration. This was washed with THF, methanol and water, and air-dried, and the resultant powder were subjected to Soxhlet extraction with chloroform for 4 hours (100 °C). The solid after the extraction was collected as much as possible and dried (60 °C) in a vacuum to obtain 11.9 mg of powder (d).

### (v) Polyfluorene by Chain Polycondensation

To 150 mg of 2-bromo-9,9-dioctylfluorene-7-boronic acid catechol ester were added 8 mL of THF and 5 mL of 2M aqueous Na₂CO₃ solution, and then the air in the system was replaced with argon gas. Thereto were added 2mL of THF solution of 6.0 mg of ((t-Bu)₃P)Pd(Ph)Br, and they were agitated at room temperature for 30 minutes, and then the oil phase was batched off. To the oil phase batched off were added 5 mL of 2N hydrochloric acid and 20 mL of methanol, and the resultant precipitate was filtered and washed with water and methanol, and then dried (60°C) in a vacuum to obtain 84 mg of polyfluorene powder (e), which emit blue light on receiving irradiation of an ultraviolet light having a wavelength of 365 nm.

When the molecular weight of this polymer was measured with gel permeation chromatography (GPC), the number average molecular weight (Mn) calculated in terms of polystyrene was 25000, and the molecular weight distribution (Mw/Mn) was 1.8 (herein, Mw indicates the weight average molecular weight calculated in terms of polystyrene, which was measured with GPC).

### <Evaluation Example 1>

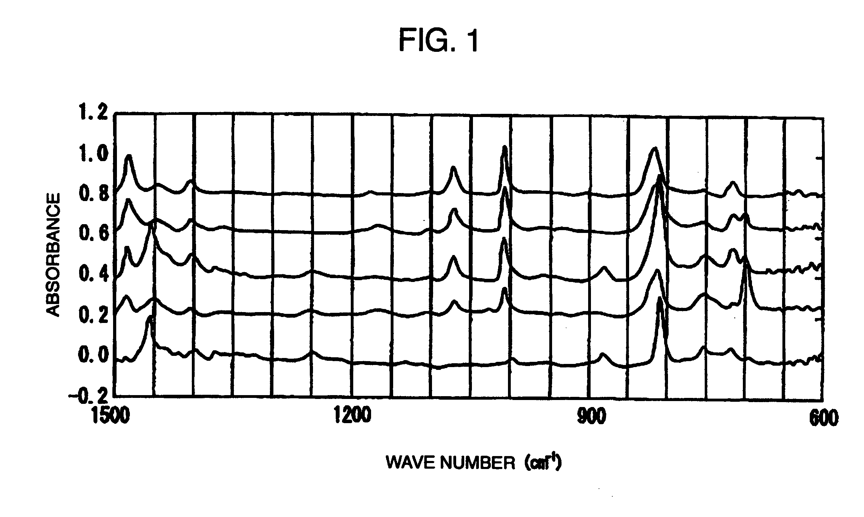

FT-IR spectra of the above-mentioned powder (a) to (e) were measured (the number of times of integrations, 12 times) by use of an infrared spectrometer (JASCO Corp. FT/IR-460 Plus) equipped with a single reflection ATR apparatus (Pike MIRacle). The spectra are shown in Fig. 1. Spectra a to e correspond to powder (a) to (e) respectively. In spectrum a (polystyrene gel having bromo groups) an absorption is seen at 1485 cm⁻¹, whereas in spectrum e (polyfluorene) an absorption is seen at 1455 cm⁻¹. When the spectra intensity are normarized on the basis of the peak height at 1485 cm⁻¹, the peak at 1455 cm⁻¹ in spectrum c is higher than that in spectrum d, and it is suggested that more polyfluorene chains are bonded to the gel in spectrum c than in spectrum d. This is supported also by the change of peaks in 820 cm⁻¹ to 810 cm⁻¹.

Elemental analyses (C, H, N: automatic analysis method; Br: ion chromatography; P, Pd: ICP emission spectrometry) of powder (a) to (d) were carried out. From unit composition ratios wherein errors fell within 5% when units constituting powder (a) to (d) were presumed and weight compositions of six kinds of atoms consisting of C, H, N, Br, P and Pd were simulated by adjusting composition ratios, it was clarified that in powder (c) fluorene 3.5 times fluorene in powder (d) is bonded to the same amount of gel. Furthermore, by use of this result and the surface area (16.21 m²/g as measured by BET method) of powder (a), the density of polyfluorene chains in powder (c) was calculated to be 4.9/nm², and therefore it was clarified that polyfluorene chains are bonded in a very high density.

Thus, according to the production method of the present invention, an aromatic polymer can be bonded to a substrate at a higher efficiency than in the conventional method. Furthermore, as mentioned previously, owing to the property of chain polycondensation, the lengths of polymer chains bonded to a substrate are controlled, and molecular weight distribution is narrow.

### <Synthesis Example 1> (Synthesis of 2-(4'-Bromophenyl)ethanethiol)

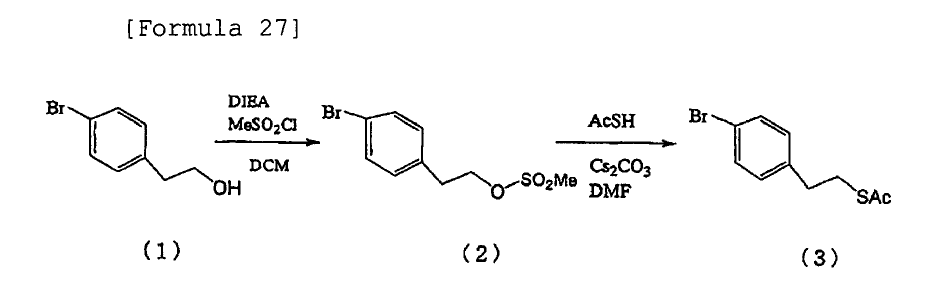

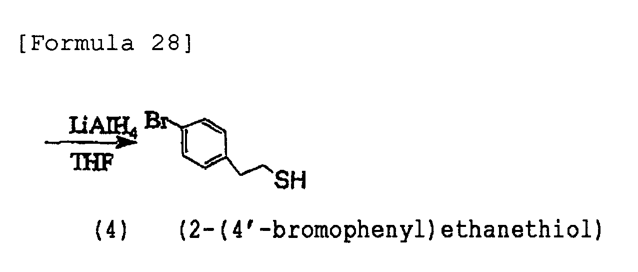

### • Synthesis of Compound (2)

Mixing of 15.0 g (74.6 mmol) of 4-bromophenethyl alcohol (compound (1)), 350 mL of dehydrated dichloromethane, and 12.8 g (89.5 mmol) of N,N'-diisopropylethylamine (DIEA) was carried out, and they were agitated at room temperature for 30 minutes, and then the reaction mixture was cooled to -20 °C in a dry ice-acetone bath, and 10.25 g (89.5 mmol) of methanesufonylchloride was dropped therein in 8 minutes. The resultant mixture was agitated at -20 °C for 2 hours, then poured in a mixture of 250 mL of water and 100 mL of 1N aqueous HCl solution, and separated into two liquids. The organic layer was taken out, the aqueous layer was washed twice with 200 mL of dichloromethane (DCM) to collect organic layers, which were washed with 350 mL of saturated sodium bicarbonate solution, then dried with magnesium sulfate, and then concentrated under reduced pressure to obtain white crystals, which were washed three times with 15 mL of hexane, and dried under reduced pressure all night to obtain 19.6 g of compound (2). The yield was 94.1 %. The configuration was confirmed by use of NMR.

### • Synthesis of Compound (3)

To 696 mL of DMF solution containing 19.5 g (69.9 mmol) of compound (2) was added 68.3 g (209.6 mmol) of cesium carbonate, and they were agitated at room temperature for 30 minutes. Then, 19.95 g (209.6 mmol) of thioacetic acid was added thereto at room temperature for 5 minutes, and they were agitated for 30 minutes, and thereafter the reaction mixture was added to 2800 mL of water, and they were agitated and then extracted three times with 700 mL of ethyl acetate. The organic layer was washed twice with 560 mL of water and then 280 mL of saturated salt solution, dried with sodium sulfate, and concentrated under reduced pressure to obtain 18.5 g of brown oil. This oil was subjected twice to column purification (silica gel 250 g, ethyl acetate/hexane=5/95) to obtain 14.3 g of compound (3) (pale yellow crystals). The yield was 79.0 %. The configuration was confirmed by use of NMR.

### • Synthesis of Compound (4)

Into a reaction vessel under nitrogen atmosphere, were added 8.08 g (213.0 mmol) of lithium aluminum hydride and then 276 mL of dehydrated THF. They were cooled in an ice-water bath, and 552 mL of dehydrated THF solution containing 13.8 g (53.25 mmol) of compound (3) was dropped therein in 2 hours, while stirring at an internal temperature of about 0 °C. After dropping the ice-water bath was removed, and agitation was carried out at ambient temperature for 2 hours, and then they were cooled in the ice-water bath, and 276 mL of purified water was dropped therein in 30 minutes at an internal temperature of 2 to 5 °C, and then 552 mL of 1N aqueous HCl solution was added therein. They were extracted 3 times with 414 mL of ethyl acetate, and the combined organic layers were washed with 138 mL of saturated salt solution and then concentrated under reduced pressure. The resultant residue in an amount of 13.5 g was subjected to column purification (silica gel 550 g, hexane, twice) to obtain 9.11 g of compound (4) (2-(4'-bromophenyl)ethanethiol). The yield was 78.8 %. The configuration was confirmed by use of NMR.

### <Example 2>

### (i) Synthesis of 2-(4'-Bromophenyl)ethanethiol Supported on Gold Electrode

A glass sheet, on which gold was deposited as an electrode, was exposed to ozone gas for 2 minutes, and thereby fouling on the surface of the gold electrode was removed. This gold electrode was immersed in 26.5 mL of ethanol solution containing 23 mg (0.11 mmol) of 2-(4'-bromophenyl)ethanethiol obtained in the above Synthesis Example 1 and left at rest for one day, and then taken out, washed with ethanol, and dried by spraying dry nitrogen gas. To the surface of the gold electrode thus treated are bonded groups represented by the formula: -S-CH₂CH₂-(C₆H₄)-Br, though the bonding form is not completely clear.

### (ii) Introduction of Pd Complex to 2-(4'-Bromophenyl)ethanethiol Supported on Gold Electrode

To the gold electrode obtained in (i) and 247.6 mg (0.093 mmol) of Pd(P(t-Bu)₃) in a globe box was added 6.1 mL of toluene, and they were agitated at 70 °C for 2 hours and cooled to room temperature. The gold electrode was taken out in the globe box, washed 5 times with 4 mL of toluene, and dried. To the surface of the gold electrode thus treated are bonded groups represented by the formula: -S-CH₂CH₂-(C₆H₄)-PdBr(Pt-Bu₃), though the bonding form is not completely clear.

### (iii) Chain Polycondensation on Gold Electrode, to Which Pd Complex Is Introduced

In the globe box 221.6 mg of 2-bromo-9,9-dioctylfluorene-7-boronic acid catechol ester and 15 mL of THF were mixed, 7.5 mL of 2M aqueous Na₂CO₃ solution was added therein, the gold electrode obtained in (ii) was immersed therein, and they were agitated at room temperature for 5 hours and 30 minutes. The gold electrode was taken out, washed in the order of 3 times with 4 mL of chloroform, 3 times with 4 mL of methanol, 3 times with 4 mL of distilled water, 3 times with 4 mL of methanol, and 3 times with 4 mL of chloroform, and dried. The resultant electrode emitted blue light on irradiation of an ultraviolet light having a wave length of 365 nm. Therefore, it was confirmed that polyfluorene chains are produced in the state of being bonded to the gold electrode surface.

### <Example 3>

### (iv) Synthesis of p-Bromobenzenethiol Supported on Gold Electrode

A glass sheet, on which gold was deposited as an electrode, was exposed to ozone gas for 1 minute, and thereby fouling on the surface of the gold electrode was removed. This gold electrode was immersed in ethanol solution (4 mM) of p-bromobenzenethiol and left at rest for one day, and then taken out, washed with ethanol, and dried by spraying dry nitrogen gas. To the surface of the gold electrode (referred to as substrate (1)) thus treated are bonded groups represented by the formula: -S-(C₆H₄)-Br, though the bonding form is not completely clear.

### (v) Introduction of Pd Complex to p-Bromobenzenethiol Supported on Gold Electrode

In a globe box, substrate (1) was immersed in toluene solution (15 mM) of Pd(P(t-Bu)₃)₂, and they were agitated at 70 °C for 2 hours and cooled to room temperature. The gold electrode was taken out in the globe box and immersed in toluene, and after it was taken out, washing of pouring toluene was repeated twice, and the electrode was dried by spraying nitrogen gas. To the surface of the gold electrode (referred to as substrate (2)) thus treated are bonded groups represented by the formula: -S-(C₆H₄)-PdBr(Pt-Bu₃), though the bonding form is not completely clear.

### (vi) Chain Polycondensation on Gold Electrode, to Which Pd Complex Is Introduced

In a globe box 219.8 mg (0.374 mmol) of 2-bromo-9,9-dioctylfluorene-7-boronic acid catechol ester and 15 mL of THF were mixed, 7.5 mL of 2M aqueous Na₂CO₃ solution was added therein, substrate (2) was immersed therein, and they were agitated at room temperature for 5 hours and 30 minutes. The gold electrode was taken out, washed sufficiently with toluene, distilled water, and methanol, and dried by spraying nitrogen gas. The resultant electrode emitted blue light on irradiation of an ultraviolet light having a wave length of 365 nm. Therefore, it was confirmed that polyfluorene chains are produced in the state of being bonded to the gold electrode surface. On the other hand, even though the polymerization solution was dropped in methanol (poor solvent for polyfluorene), no precipitation took place, and it was confirmed that all of the resultant polymers are bonded to the gold electrode surface. This indicates that no useless monomer consumption was caused.

### <Synthesis Example 2>

### Synthesis Method of 2-Bromo-9,9-dioctylfluorene-7-boronic Acid Pinacol Ester

Under an inert gas atmosphere, 184.6 g (0.337 mol) of 2,7-dibromo-9,9-dioctylfluorene and 2310 mL of t-butyl methyl ether were added in a reaction vessel, 1.6 M hexane solution of n-butyllithium was dropped therein at -70 °C, and they were warmed to 0 °C and then cooled again to -65 °C. Next, at a temperature of not more than -60 °C, 68.89 g (0.370 mol) of isopropoxy-4,4,5,5-tetramethyl-1,3,2-dioxaborolane was dropped therein, and they were agitated at the same temperature for 1 hour and agitated at room temperature for 1 hour. Subsequently, 460 mL of distilled water was added therein at -20 °C, and after agitation the aqueous layer was removed from the organic layer. To the organic layer was added 650 mL of saturated salt solution, and they were agitated and operation of removing the aqueous layer from the organic layer was repeated twice, and the resultant organic layer was dried with anhydrous magnesium sulfate, and the solvent was distilled off. Subsequently, silica gel column chromatography using hexane and ethyl acetate as a developing solvent was carried out, the solvent was distilled off, and drying under reduced pressure was conducted to obtain 115 g of white powder. The results of ¹H NMR measurement of the resultant product were as follows.

¹H NMR (CDCl₃, 299.4 MHz, rt): d 0.56 (br, 4H), 0.82 (t, 6H), 0.93 - 1.28 (m, 20H), 1.38 (s, 12H), 1.78 - 2.13 (m, 4H), 7.39 - 7.49 (m, 2H), 7.52 - 7.60 (m, 1H), 7.62 - 7.68 (m, 1H), 7.69 - 7.74 (m, 1H), 7.76 - 7.85 (m, 1H)

### <Example 4>

### (vii) Chain Polycondensation on Gold Electrode, to Which Pd Complex Is Introduced

In the globe box 148.7 mg (0.250 mmol) of 2-bromo-9,9-dioctylfluorene-7-boronic acid pinacol ester and 10 mL of THF were mixed, 5.0 mL of 2M aqueous Na₂CO₃ solution was added therein, substrate (2) was immersed therein, and they were agitated at room temperature for 5 hours and 30 minutes. The gold electrode was taken out, washed sufficiently with toluene, distilled water, and methanol, and dried by spraying nitrogen gas. The resultant electrode emitted blue light on irradiation of an ultraviolet light having a wave length of 365 nm. Therefore, it was confirmed that polyfluorene chains are produced in the state of being bonded to the gold electrode surface. On one hand, even though the polymerization solution was dropped in methanol (poor solvent for polyfluorene), no precipitation took place, and it was confirmed that all of the resultant polymers are bonded to the gold electrode surface. This indicates that no useless monomer consumption was caused.

### <Synthesis Example 3>

### Synthesis of p-Iodobenzenethiol

Under an inert gas atmosphere, 46.0 g (152 mmol) of p-iodobenzenesulfonyl chloride, 460 mL of acetic acid, and 68.1 g (1.22 mmol) of zinc were mixed and agitated for 6 hours under reflux. After left at rest for one night, the reaction mixture was added to a mixture of saturated aqueous ammonium chloride solution and distilled water, and they were agitated and filtered. The substance on the filter was washed with t-butyl methyl ether, and the filtrate and washings were mixed and extracted twice with t-butyl methyl ether. The organic layer was washed with saturated salt solution, dried with anhydrous sodium sulfate, and concentrated. The concentrated solution was developed with silica gel column chromatography and eluted with t-butyl methyl ether. The solvent of the eluted solution was distilled off, and through recrystallization from t-butyl methyl ether and hexane there was obtained 5.6 g of p-iodobenzenethiol.

After completion of the reaction, to 42 g of the precipitate separated by filtration were added 840 mL of 1,4-dioxane, 39.6 g (156 mmol) of I₂, and 409 g (1.56 mol) of PPh₃, and they were agitated under reflux for 5 hours. They were cooled to room temperature, t-butyl methyl ether and distilled water were added therein and they were agitated, and the aqueous layer was removed from the organic layer. Saturated salt solution was added to the organic layer and they were agitated, the aqueous layer was removed from the organic layer, and the resultant organic layer was dried with anhydrous sodium sulfate and the solvent was distilled off. Subsequently, silica gel chromatography was carried out by using hexane as a developing solvent, and the solvent was distilled off. Hexane was added to the resultant solid and extraction was carried out, the extracted solution was concentrated and the supernatant liquid was recovered, the solvent was distilled off and drying under reduced pressure was carried out to obtain 8.03 g of white solid.

### <Example 5>

### (viii) Synthesis of p-Iodobenzenethiol Supported on Gold Electrode

A glass sheet, on which gold was deposited as an electrode, was exposed to ozone gas for 1 minute, and thereby fouling on the surface of the gold electrode was removed. This gold electrode was immersed in ethanol solution (4 mM) of p-iodobenzenethiol and left at rest for one day, and then taken out, washed with ethanol, and dried by spraying dry nitrogen gas. To the surface of the gold electrode (referred to as substrate (3)) thus treated are bonded groups represented by the formula: -S-(C₆H₄)-I, though the bonding form is not completely clear.

### (ix) Introduction of Pd Complex to p-Iodobenzenethiol Supported on Gold Electrode

In a globe box, substrate (3) was immersed in toluene solution (15 mM) of Pd(P(t-Bu)₃)₂, and they were agitated at 70 °C for 2 hours and cooled to room temperature. The gold electrode was taken out in the globe box and immersed in toluene, and after it was taken out, washing of pouring toluene was repeated twice, and the electrode was dried by spraying nitrogen gas. To the surface of the gold electrode (referred to as substrate (4)) thus treated are bonded groups represented by the formula: -S-(C₆H₄)-PdI(Pt-Bu₃), though the bonding form is not completely clear.

### (x) Chain Polycondensation on Gold Electrode, to Which Pd Complex Is Introduced

In a globe box 149.6 mg (0.251 mmol) of 2-bromo-9,9-dioctylfluorene-7-boronic acid pinacol ester and 10 mL of THF were mixed, 5.0 mL of 2M aqueous Na₂CO₃ solution was added therein, substrate (4) was immersed therein, and they were agitated at room temperature for 5 hours and 30 minutes. The gold electrode was taken out, washed sufficiently with toluene, distilled water, and methanol, and dried by spraying nitrogen gas. The resultant electrode emitted blue light on irradiation of an ultraviolet light having a wave length of 365 nm. Therefore, it was confirmed that polyfluorene chains are produced in the state of being bonded to the gold electrode surface. The film thickness was 20 nm to 100nm as measured by a stylus type film thickness gauge (DEKTAK manufactured by Veeco Company). On the other hand, even though the polymerization solution was dropped in methanol (poor solvent for polyfluorene), no precipitation took place, and it was confirmed that all of the resultant polymers are bonded to the gold electrode surface. This indicates that no useless monomer consumption was caused.

### <Synthesis Example 4>

### Synthesis of 4-Bromo-2-hexyloxyphenylboronic Acid Pinacol Ester

Under an inert gas atmosphere, in 200 mL four-necked flask 2.0 g (6.0 mmol) of 1,4-dibromo-2-hexyloxybenzene was dissolved in 60 mL of dehydrated t-butyl methyl ether, and they were cooled to -70 °C. Next, 1.6 M hexane solution of n-butyllithium was dropped therein at -70 °C in 6 minutes, and they were agitated at -70 °C for 2 hours. Subsequently, 1.5 mL of 2-isopropoxy-4,4,5,5-tetramethyl-1,3,2-dioxaborolane was dropped therein at -70 °C in 1 minute, and they were warmed to room temperature in 1 hour and 15 minutes while stirring and agitation was continued for 10 hours. Subsequently, 30 mL of distilled water was added therein at 0 °C, they were warmed to room temperature and then agitated for 30 minutes, and ethyl acetate was added therein and they were agitated and then the organic layer was separated from the aqueous layer. The organic layer was concentrated and left at rest for one night at -5 °C to obtain 2.3 g of a solid. Of the resultant solid, 1.1 grams were dissolved in 2 mL of methanol at 40 °C, and they were cooled to room temperature to deposit crystals. The resultant crystals were filtered and dried to obtain 0.5 g of the object. GC-MS: [M+]=382

### <Example 6>

### (xi) Chain Polycondensation on Gold Electrode, to Which Pd Complex Is Introduced

In a globe box 96.7 mg (0.252 mmol) of 4-bromo-2-hexyloxyphenylboronic acid pinacol ester and 10 mL of THF were mixed, 5.0 mL of 2M aqueous Na₂CO₃ solution was added therein, substrate (4) was immersed therein, and they were agitated at room temperature for 4 hours. The gold electrode was taken out, washed sufficiently with toluene, distilled water, and methanol, and dried by spraying nitrogen gas. The resultant electrode emitted blue light on irradiation of an ultraviolet light having a wave length of 365 nm. Therefore, it was confirmed that polyfluorene chains are produced in the state of being bonded to the gold electrode surface. On the other hand, even though the polymerization solution was dropped in methanol (poor solvent for polyfluorene), no precipitation took place, and it was confirmed that all of the resultant polymers are bonded to the gold electrode surface. This indicates that no useless monomer consumption was caused.

### <Comparative Example 2> (Spin-coated Film of Fluorene Polymer)

Under an inert gas atmosphere, 149 mg (0.25 mmol) of 2-bromo-9,9-dioctylfluorene-7-boronic acid pinacol ester and 38 mL of THF were mixed to produce the solution, and 5 mL of 2M aqueous Na₂CO₃ solution was added therein. A yellow solution wherein 5.8 mg (0.025 mmol, 5 mol %) of (t-Bu₃P)Pd(Ph)Br (J. Am. Chem. Soc. 2004, 126, 1184-1194) had been separately dissolved in 2 mL of THF, was charged in one lump into the above monomer solution under an inert gas atmosphere, and they were agitated at room temperature for 3 hours and 20 minutes. At room temperature the aqueous layer was removed, and then to 14.9 g of the resultant organic layer was added 20 mL of 2 N hydrochloric acid and they were agitated, and the mixture was dropped in 40 mL of methanol. The polymer deposited was taken out by filtration, washed with distilled water and methanol, and dried under reduced pressure to obtain a polymer as yellow powder. Two mg of the resultant polymer was dissolved in 1.9 g of toluene, and from the solution a film was produced on a glass sheet, on which gold was deposited as an electrode, by spin coating at a rotational speed of 2500 rpm for 5 seconds and a rotational speed of 3500 rpm for 15 seconds.

### <Evaluation Example 2, Emission Spectra>

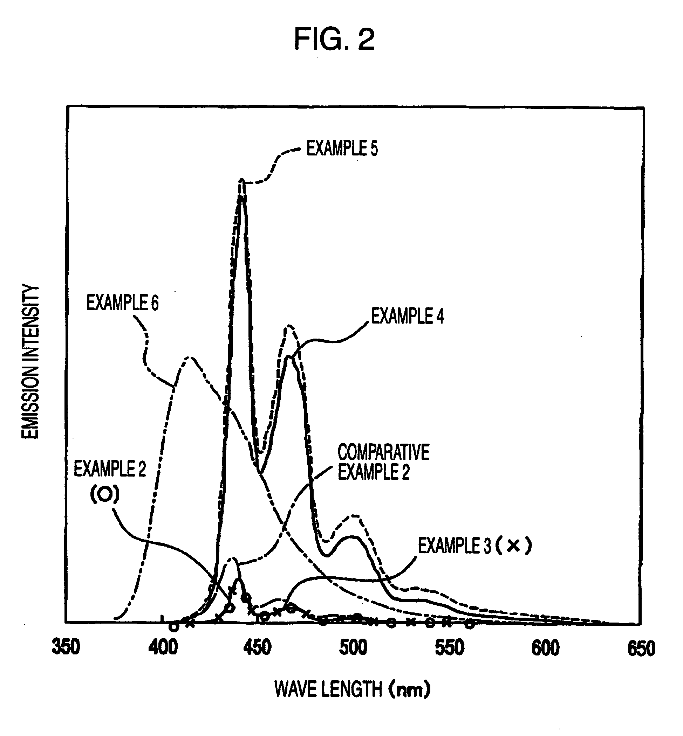

An excitation light having a wave length of 350 nm was irradiated to each of the powder (c) obtained in Example 1 and the electrodes obtained in Examples 2 to 6, and the resultant spectra were measured. The results are shown in Fig. 2. The curve (plotted with O) of Example 2 and that (plotted with X) of Example 3 were obtained in the indistinguishable state of being superimposed.
From these results, it can be clearly confirmed that aromatic polymers corresponding to starting materials have been produced in the state of being bonded to substrates.

### <Example 7>

### (xii) Chain Polycondensation on Gold Electrode, to Which Pd Complex Is Introduced

In a globe box 71.0 mg (0.25 mmol) of 5-bromopyridine-3-boronic acid pinacol ester (Aldrich) and 10 mL of THF were mixed, 5.0 mL of 2M aqueous Na₂CO₃ solution was added therein, substrate (2) was immersed therein, and they were agitated at room temperature for 4 hours and 10 minutes. The gold electrode was taken out, washed sufficiently with toluene, distilled water, and methanol, and dried by spraying nitrogen gas. When the UV spectrum of the resultant electrode was measured with double beams using an untreated gold electrode as a reference by use of an integrating sphere, an absorption having a maximum at 360 nm was observed in the area of from 300 nm to 600 nm. Therefore, it was confirmed that polypyridine chains are produced in the state of being bonded to the gold electrode surface.

### <Example 8> Low Molecular Model Reaction

### Synthesis of p-Bromobenzenethiol Supported on Gold Particles

Gold particles were exposed to ozone gas for 1 minute, and thereby fouling on the surfaces thereof was removed. The gold particles were immersed in ethanol solution (4 mM) of p-bromobenzenethiol and left at rest for one day, and then collected by filtration, washed with ethanol, and dried by spraying dry nitrogen gas. To the surfaces of the gold particles (referred to as gold particles (1)) thus treated are bonded groups represented by the formula: -S-(C₆H₄)-Br, though the bonding form is not completely clear.

### Introduction of Pd Complex to p-Bromobenzenethiol Supported on Gold Particles

In a globe box, gold particles (1) were immersed in toluene solution (15 mM) of Pd(P(t-Bu)₃)₂, and they were agitated at 70 °C for 2 hours and cooled to room temperature. The reaction vessel was left at rest in the globe box and the supernatant liquid was removed, and toluene was added therein and the operation of removing the supernatant liquid was repeated again. Subsequently, the gold particles were collected by filtration, sufficiently washed with toluene, and dried by spraying nitrogen gas. To the surfaces of the gold particles (referred to as gold particles (2)) thus treated are bonded groups represented by the formula: -S-(C₆H₄)-PdBr(Pt-Bu₃), though the bonding form is not completely clear.

### Chain Polycondensation on Gold Particles, to Which Pd Complex Is Introduced

A solution of 51.6 mg (0.25 mmol) of benzeneboronic acid catechol ester and 10 mL of THF prepared in a globe box was added to gold particles (2). Subsequently, 5.0 mL of 2M aqueous Na₂CO₃ solution was added therein, and they were agitated at room temperature for 3 hours and 40 minutes. The gold particles were collected by filtration, washed sufficiently with toluene, distilled water, and methanol, and dried by spraying nitrogen gas (referred to as gold particles (3)).

### Detachment Operation of Material Bonded to Gold Particles

Chloroform was added to gold particles (3) and refluxed at 80 °C for 6 hours and 10 minutes, the gold particles were separated by filtration, and the extract was concentrated to obtain a trace amount of white solid. When LC-MS (APPI/posi) was measured, m/z=370(M+) was observed, and it was indicated that (C₆H₅)-(C₆H₄)-S-S(C₆H₄)-(C₆H₅) is contained in the white solid. The compound observed is the dimerization product of -SC₆H₄C₆H₅, which was present on the surfaces of gold particles, by heat treatment. From this fact, it was clarified that the Pd complex was introduced to -S-(C₆H₄)-Br bonded to the surfaces of gold particles and the condensation reaction proceeded.

### Industrial Applicability

When a substrate is, for example, an electrode, electricity can be efficiently flowed from the bonded portion of an aromatic polymer bonded to the electrode through the polymer main chain, and hence electrically excellent characteristics are shown. Thus, the present invention is useful for advanced functional materials such as conductive materials, photoelectric conversion materials, luminescent materials, materials for a battery, electronic part materials, and the like.

### Brief Description of the Drawings

[Fig. 1] shows the FT-IR spectra of the powder (a) to (e) obtained in Example 1 and Comparative Example 1.
[Fig. 2] shows the emission spectra obtained by irradiating an excitation light having a wave length of 350 nm to each of the powder (c) obtained in Example 1 and the electrodes obtained in Examples 2 to 6.

## Claims

1. A method for producing a structure having a substrate and an aromatic polymer bonded to the substrate, which comprises the step of polycondensing an aromatic compound represented by the undermentioned general formula (I) in a solvent in the presence of a polymerization catalyst and a substrate having a group represented by the undermentioned general formula (II). 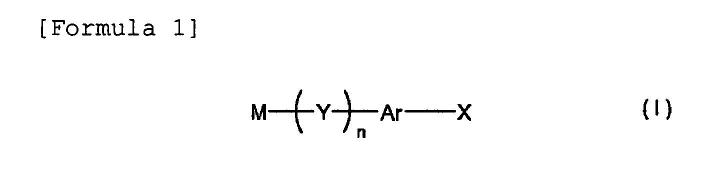
[in the formula, Ar is a divalent group comprising an aromatic ring,
X is a halogen atom, nitro group, or a monovalent group represented by -SO₃Q wherein Q stands for a substituted or unsubstituted hydrocarbon group,
Y is an oxygen atom, sulfur atom, imino group, a substituted imino group, ethenylene group, a substituted ethenylene group or ethynylene group,
n is 0 or 1,
M is a hydrogen atom, -B(OQ¹)₂ wherein two Q¹ stand for independently hydrogen atom or a hydrocarbon group or are bonded together to form a ring, -Si(Q²)₃ wherein Q² is a hydrocarbon group, -Sn(Q³) wherein Q³ is a hydrocarbon group, or -Z¹(Z²)ₘ wherein Z¹ is a metal atom or a metal ion, Z² is a counter anion, and m is an integer of 0 or more.] 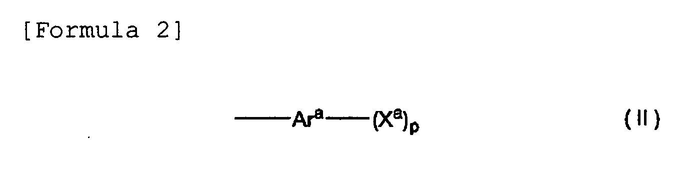
[in the formula, Ar^{a} is a group having a valence of p+1 and comprising an aromatic ring, X^{a} is a halogen atom or a monovalent group represented by -SO₃Q^{a} wherein Q^{a} stands for a substituted or unsubstituted hydrocarbon group, p is an integer of 1 or more, and when p is an integer of 2 or more, the existing plural X^{a} are same as or different from each other.]

2. The method for producing a structure according to Claim 1, wherein said polymerization catalyst is a palladium complex.

3. The method for producing a structure according to Claim 1 or 2, wherein said substrate having a group represented by general formula (II) is produced by reacting a substrate with a coupling agent having said group represented by general formula (II) and a functional group.

4. The method for producing a structure according to Claim 3, wherein said coupling agent having a group represented by general formula (II) and a functional group is at least one kind selected from the group consisting of a thiol type coupling agent and a silane coupling agent.

5. The method for producing a structure according to any one of Claims 2 to 4, wherein said palladium complex contains as a ligand a phosphine compound represented by the undermentioned general formula (III).
P(R¹)₃ (III)
(in the formula, three R¹ are same as or different from each other and stand for a group represented by the undermentioned formula (IV) or a group represented by the undermentioned formula (V), but at least one of three R¹ stand for a group represented by the undermentioned formula (IV).)
-C(R²)₃ (IV)
(in the formula, three R² are same as or different from each other and stand for hydrogen atom or a substituted or unsubstituted hydrocarbon group, but two or more R² do not stand for a hydrogen atom and two R² among three R² can be bonded together to form a ring.) 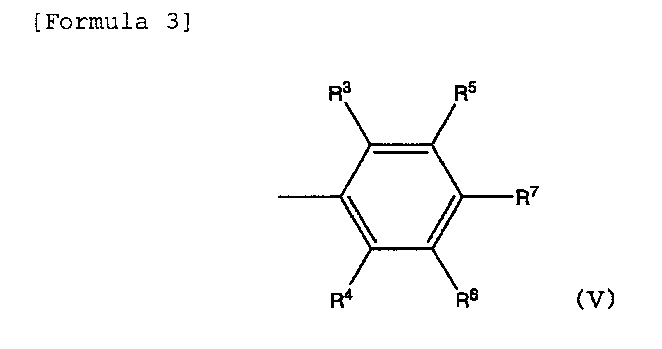 (in the formula, R³ to R⁷ independently stand for hydrogen atom, a substituted or unsubstituted hydrocarbon group, a substituted or unsubstituted hydrocarbon oxy group, a substituted or unsubstituted hydrocarbon-disubstituted amino group, a substituted or unsubstituted hydrocarbon mercapto group, a substituted or unsubstituted hydrocarbon carbonyl group, a substituted or unsubstituted hydrocarbon oxycarbonyl group, a substituted or unsubstituted hydrocarbon-disubstituted aminocarbonyl group, or a substituted or unsubstituted hydrocarbon sulfonyl group; at least one of R³ and R⁴ stands for a group other than hydrogen atom; and in at least one of combinations of R³ and R⁵, R⁵ and R⁷, R⁴ and R⁶, and R⁶ and R⁷, the two groups can be bonded together to form a ring.)

6. The method for producing a structure according to Claim 5, wherein R³ to R⁷ in general formula (V) independently stand for hydrogen atom or a substituted or unsubstituted hydrocarbon group.

7. The method for producing a structure according to any one of Claims 1 to 6, wherein said aromatic compound is a compound represented by general formula (I) wherein M is -B(OQ¹)₂ wherein two Q¹ stand for independently hydrogen atom or a hydrocarbon group or are bonded together to form a ring, and Ar, X, Y, and n are as defined above;
said polymerization catalyst is the palladium complex having as a ligand a phosphine compound represented by general formula (III) as stated in Claim 5; and
said polycondensation is carried out by Suzuki coupling in the presence of a base.

8. The method for producing a structure according to any one of Claims 1 to 7, wherein said divalent group comprising an aromatic ring represented by Ar is a group formed by removing two hydrogen atoms bonded to ring-constituting elements from a monocyclic aromatic ring, a condensed polycyclic aromatic ring, an aromatic ring assembly, or a bridged polycyclic aromatic ring.

9. The method for producing a structure according to Claim 8, wherein said divalent group comprising an aromatic ring represented by Ar is a group formed by removing two hydrogen atoms bonded to ring-constituting elements from a bridged polycyclic aromatic ring.

10. The method for producing a structure according to Claim 9, wherein said group formed by removing two hydrogen atoms bonded to ring-constituting elements from a bridged polycyclic aromatic ring is fluorenediyl group.

11. The method for producing a structure according to Claim 8, wherein said divalent group comprising an aromatic ring represented by Ar is a group formed by removing two hydrogen atoms bonded to ring-constituting elements from a monocyclic aromatic ring.

12. The method for producing a structure according to Claim 11, wherein said group formed by removing two hydrogen atoms bonded to ring-constituting elements from a monocyclic aromatic ring is phenylene group.

13. The method for producing a structure according to Claim 11, wherein said group formed by removing two hydrogen atoms bonded to ring-constituting elements from a monocyclic aromatic ring is pyridinylene group.

14. A structure having a substrate and an aromatic polymer bonded to the substrate, which is obtained by the production method stated in any one of Claims 1 to 13.

15. A structure having a conductive substrate and an aromatic polymer chain having a configuration represented by the undermentioned general formula (VI), which is bonded to the conductive substrate: 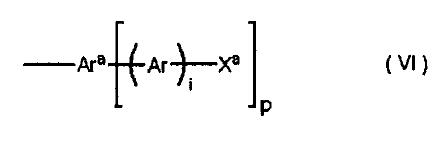 , wherein Ar, Ar^{a}, X^{a} and p are as defined in Claim 1, and i is a number average polymerization degree of the repeating configuration Ar.

16. The structure according to Claim 15, wherein said divalent group comprising an aromatic ring represented by Ar is a group formed by removing two hydrogen atoms bonded to ring-constituting elements from a monocyclic aromatic ring, a condensed polycyclic aromatic ring, an aromatic ring assembly, or a bridged polycyclic aromatic ring.

17. The structure according to Claim 16, wherein said divalent group comprising an aromatic ring represented by Ar is a group formed by removing two hydrogen atoms bonded to ring-constituting elements from a bridged polycyclic aromatic ring.

18. The structure according to Claim 17, wherein said group formed by removing two hydrogen atoms bonded to ring-constituting elements from a bridged polycyclic aromatic ring is a fluorenediyl group.

19. The structure according to Claim 16, wherein said divalent group comprising an aromatic ring represented by Ar is a group formed by removing two hydrogen atoms bonded to ring-constituting elements from a monocyclic aromatic ring.

20. The structure according to Claim 19, wherein said group formed by removing two hydrogen atoms bonded to ring-constituting elements from a monocyclic aromatic ring is a phenylene group.

21. The structure according to Claim 19, wherein said group formed by removing two hydrogen atoms bonded to ring-constituting elements from a monocyclic aromatic ring is pyridinediyl group.

22. The structure according to Claim 15, wherein said conductive substrate comprises a material containing a poor metal, a noble metal, or an oxide.

23. The structure according to any one of Claims 15 to 22, wherein an intermediate value length of said aromatic polymer chain between the longest one and the shortest one is in the range of 0.1 nm to 10 cm.

24. An electronic device comprising the structure according to any one of Claims 15 to 23.

25. The electronic device according to Claim 24, which is a luminescent device.

26. The electronic device according to Claim 24, which is a photoelectric conversion device.
